(19) Europäisches Patentamt
European Patent Office
Office européen des brevets

(11) **EP 2 833 391 A1**

(12) **EUROPEAN PATENT APPLICATION**
published in accordance with Art. 153(4) EPC

(43) Date of publication:
**04.02.2015 Bulletin 2015/06**

(51) Int Cl.:
*H01L 21/20* (2006.01)    *H01L 21/208* (2006.01)
*H01L 21/225* (2006.01)    *H01L 21/336* (2006.01)
*H01L 29/786* (2006.01)    *H01L 31/04* (2014.01)

(21) Application number: 13768368.6

(22) Date of filing: **29.03.2013**

(86) International application number:
**PCT/JP2013/059629**

(87) International publication number:
**WO 2013/147202 (03.10.2013 Gazette 2013/40)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **30.03.2012   JP 2012078902**
              **19.10.2012   JP 2012232206**
              **15.01.2013   JP 2013004670**

(71) Applicant: **Teijin Limited**
**Osaka-shi, Osaka 541-0054 (JP)**

(72) Inventors:
• **IMAMURA, Tetsuya**
  **Hino-shi**
  **Tokyo 191-0065 (JP)**
• **TOMIZAWA, Yuka**
  **Hino-shi**
  **Tokyo 191-0065 (JP)**
• **IKEDA, Yoshinori**
  **Hino-shi**
  **Tokyo 191-0065 (JP)**

(74) Representative: **Carpmaels & Ransford LLP**
**One Southampton Row**
**London WC1B 5HA (GB)**

(54) **SEMICONDUCTOR LAMINATE AND METHOD FOR MANUFACTURING SAME, METHOD FOR MANUFACTURING SEMICONDUCTOR DEVICE, SEMICONDUCTOR DEVICE, DOPANT COMPOSITION, DOPANT INJECTION LAYER, AND METHOD FOR FORMING DOPED LAYER**

(57)    A first aspect of the present invention provides a method for producing a semiconductor laminate comprising a substrate having formed thereon a silicon layer with small surface unevenness and high continuity.

The method of the first aspect of the present invention for producing a semiconductor laminate having a substrate 10 and a sintered silicon particle layer 5 on the substrate comprises (a) coating a silicon particle dispersion containing a dispersion medium and silicon particles dispersed in the dispersion medium, on a substrate 10 to form a silicon particle dispersion layer 1, (b) drying the silicon particle dispersion layer 1 to form a green silicon particle layer 2, (c) stacking a light-transmitting layer 3 on the green silicon particle layer, and (d) irradiating the green silicon particle layer 2 with light through the light-transmitting layer 3 to sinter the silicon particles constituting the green silicon particle layer 2, and thereby form a sintered silicon particle layer 5.

FIG. 1

**Description**

[TECHNICAL FIELD]

A first aspect of the present invention relates to a semiconductor laminate and a production method thereof.

A second aspect of the present invention relates to a method for manufacturing a semiconductor device. The second aspect of the present invention also relates to a semiconductor device obtainable by using the method of the second aspect of the present invention for manufacturing a semiconductor device.

A third aspect of the present invention relates to a dopant composition, a dopant injection layer, and a method for forming a doped layer. The third aspect of the present invention also relates to a method for manufacturing a semiconductor device by using the method of the third aspect of the present invention for forming a doped layer.

[BACKGROUND ART]

<<First Aspect of the Present Invention>>

The manufacture of a semiconductor device such as thin-film transistor (TFT) and solar cell involves using one silicone layer or a plurality of silicon layers stacked on a substrate such as silicon substrate.

Specifically, in the manufacture of a thin-film transistor, a polysilicon layer is formed by depositing an amorphous silicon layer on a substrate and crystallizing the amorphous silicon layer by a laser or the like.

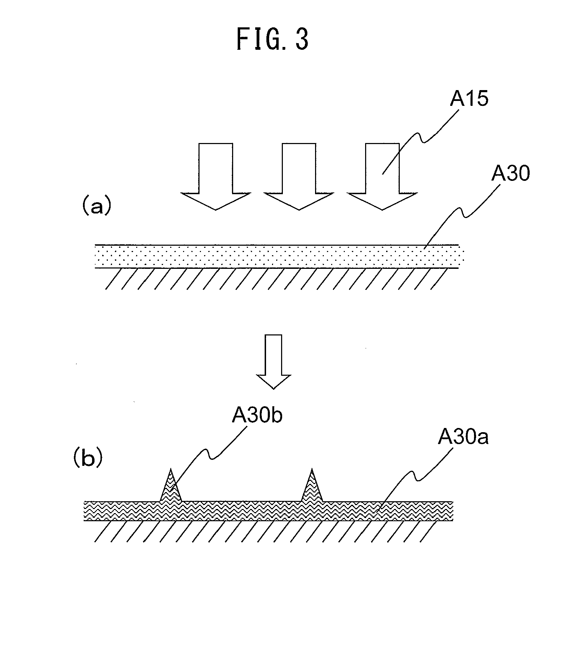

In this case, a silicon crystal sometimes extraordinarily grows during crystallization of the amorphous layer to produce a convex part on the surface of the polysilicon layer. Specifically, as shown in Fig. 3, in the case of producing a semiconductor laminate by irradiating the amorphous silicon layer (A30) with light (A15) (Fig. 3(a)), the obtained silicon layer has a convex part (A30b) protruding from the flat part (A30a). This is attributable to the fact that when solidification occurs in the course of forming a crystal after the amorphous silicon layer is melted, the solidification takes place in the final stage at grain-boundary triple points and a convex part (A30b) is produced due to volume expansion during solidification at the grain-boundary triple points.

Such a convex part on the surface may cause an interlayer short-circuit or an interlayer leakage when an insulating layer is deposited thereon, or may cause a contact failure when an electrode is formed thereon, and therefore this convex part is preferably removed. In order to remove the convex part and obtain a flat surface, it has been proposed to perform acid etching, polishing or the like (Patent Documents 1 and 2).

Also, a method for forming a sintered silicon particle-containing silicon layer by applying a silicon particle dispersion containing silicon particles to a substrate, and drying and heating the dispersion applied has been developed (Patent Documents 3 to 5).

<<Second Aspect of the Present Invention>>

In the manufacture of a certain kind of a semiconductor device, for example, a solar cell, particularly a back-contact solar cell and an PERL solar cell (Passivated Emitter, Rear Locally diffused cell), a doped layer is formed only in a selected region by injecting a dopant such as phosphorus or boron into the selected region of a semiconductor layer or substrate.

For example, in the manufacture of a back-contact solar cell, p-type and n-type doped layers and respective electrodes in contact with these doped layers are formed in a selected region on the back surface side.

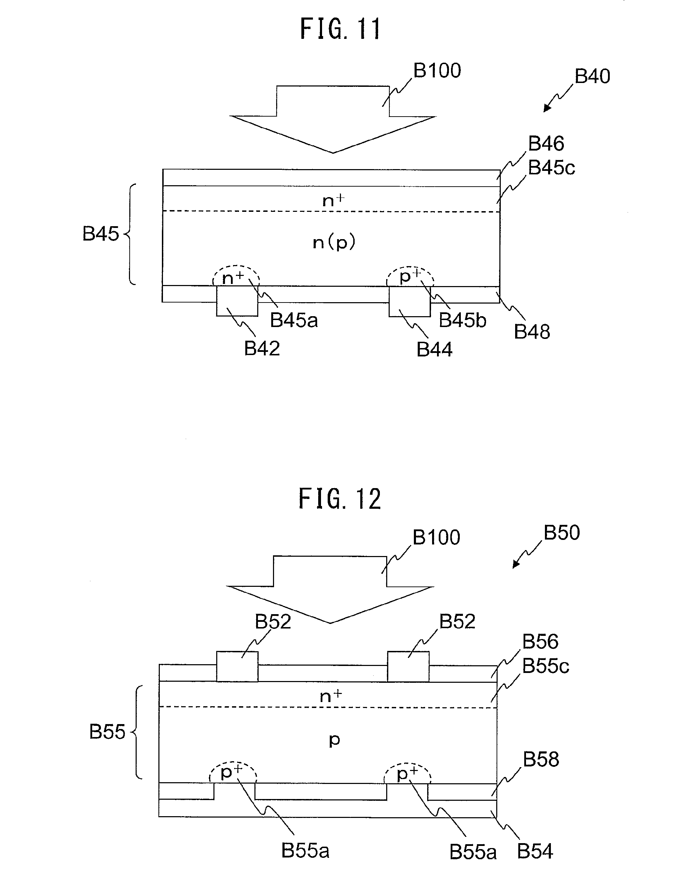

Specifically, a back-contact solar cell (B40) has, as shown in Fig. 11, a semiconductor substrate (B45) composed of an n-type (alternatively, p-type or intrinsic) semiconductor, where a passivation layer (B46) is disposed on the light-receiving surface side of the semiconductor substrate (B45) and back surface-side electrodes (B42 and B44) and a passivation layer (B48) are disposed on the back surface side of the semiconductor substrate (B45).

Furthermore, the back-contact solar cell has doped layers (back-contact layers) (B45a, B45b) each formed by selective high n-type or p-type doping of the region in contact with the electrode (B42, B44) on the back surface side of the semiconductor substrate (B45), and a doped layer (B45c) formed by high n-type doping on the light-receiving surface side of the semiconductor substrate (B45).

In the back-contact solar cell (B40), the n-type doped layer (n-type back-contact layer) (B45a) formed by n-doping at a high concentration, and the p-type doped layer (p-type back-contact layer) (B45b) formed by p-doping at a high concentration, are alternately arranged. The rest portion is an intrinsic semiconductor region, a region that is p- or n-doped at a low concentration, or a region having formed therein p-n junction, and the electromotive force is generated by the irradiation of such a region with light. The thus-generated electromotive force is collected by the n-type electrode (B42) and the p-type electrode (B44) through the n-type doped layer (B45a) and the p-type doped layer (B45b), respectively.

In the back-contact solar cell (B40), the doped layers (B45a, B45b) each formed by p- or n-doping at a high concentration are provided, whereby the electromotive force loss due to contact resistance can be kept low and the electric power generated by light (100) can be efficiently collected. Also, in the back-contact solar cell, the doped layer and the electrode, which are usually formed on the light-receiving surface side, are formed on the back surface, so that the substantial light-receiving area can be made large and in turn, the conversion efficiency of the solar cell can be enhanced.

In the manufacture of a PERL solar cell, p-type or n-type doped layers and respective electrodes in contact with these doped layers are formed in a selected region on the back surface side.

Specifically, a PERL solar cell (B50) has, as shown in Fig. 12, a semiconductor substrate (B55) composed of an n-type (alternatively, p-type or intrinsic) semiconductor, where a light-receiving surface-side electrode (B52) and a passivation layer (B56) are disposed on the light-receiving surface side of the semiconductor substrate (B55) and a back surface-side electrode (B54) and a passivation layer (B58) are disposed on the back surface side of the semiconductor substrate (B55).

Furthermore, the PERL solar cell has a doped layer (B55a) formed by selective high p-type doping of the region in contact with the back surface-side electrode (B54) of the semiconductor substrate (B55) and a doped layer (B55c) formed by high n-type doping on the light-receiving surface side of the semiconductor substrate (B55).

In the PERL solar cell (B50), an intrinsic semiconductor region, a region that is p- or n-doped at a low concentration, or a region having formed therein p-n junction, which are located between the n-type doped layer (B55c) formed by high n-doping on the light-receiving surface side and the p-type doped layer (B55a) formed by p-doping at a high concentration on the back surface side, are irradiated with light (B100), whereby the electromotive force is generated. The thus-generated electromotive force is collected by the p-type electrode (B54) and the n-type electrode through the p-type doped layer (B55a) and the n-type doped layer, respectively.

In the PERL solar cell (B50), the doped layer (B55a) formed by p-doping at a high concentration is provided, so that the electromotive force loss due to contact resistance can be kept low and the electric power generated by light (B100) can be efficiently collected. Also, in the PERL solar cell, the passivation layer formed on the back surface can suppress recombination on the back surface of the base material and in turn, the conversion efficiency of the solar cell can be enhanced.

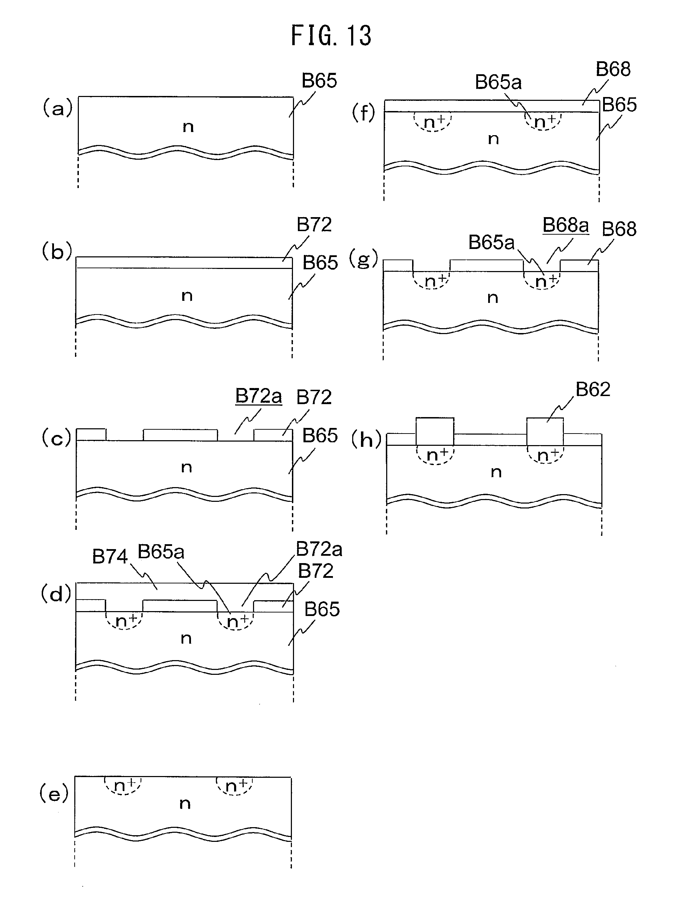

In a semiconductor device such as the solar cell above, a doped layer is formed in a selected region of a semiconductor layer or substrate, and an electrode is formed on the doped layer in the selected region. In this case, conventionally, as shown in Fig. 13, a diffusion mask layer (B72) is formed on a semiconductor substrate (B65) (Figs. 13(a) and (b)), a hole (B72a) is bored in a selected region of the diffusion mask layer (B72) to expose the semiconductor substrate (B65) (Fig. 13(c)), a doped layer (B65a) is formed through the hole (B72a) in the selected region of the semiconductor substrate by a dopant injection layer (B74) formed of, for example, a doping gas such as phosphorus oxychloride ($POCl_3$) or a coating-type doping agent (Fig. 13(d)), the diffusion mask layer (B72) and the dopant injection layer (B74) are removed (Fig. 13(e)), a passivation layer (B68) is formed on the semiconductor substrate (B65) having the doped layer (B65a) (Fig. 13(f)), a hole (B68a) is bored in a selective region of the passivation layer (B68) corresponding to the doped layer (B65a) to expose the semiconductor substrate (B65), and an electrode (B62) is formed through the hole (B68a) to thereby establish electrical contact between the doped layer (B65a) and the electrode (B62) in the selected region of the semiconductor substrate.

Also, in the case where both an n-type doped layer and a p-type doped layer must be formed as in a back-contact solar cell, the p-type doped layer is formed similarly to the n-type doped layer by repeating the steps of Figs. 13(b) to (e).

Incidentally, for boring a hole in the diffusion mask layer and the passivation layer, a photolithography, a laser or the like has been heretofore used (Patent Documents 6 and 7).

With respect to the formation of a doped layer, it has been also proposed to form a dispersion layer by coating a dispersion containing a doped silicon particle, dry and fire the dispersion layer, thereby doping the substrate, and thereafter, remove a layer derived from the silicon particles (Patent Document 8).

<<Third Aspect of the Present Invention>>

Conventionally, in the manufacture of a semiconductor device such as solar cell, when forming a doped layer in a semiconductor substrate, a dopant composition containing a dopant is coated on a semiconductor substrate, and the resulting semiconductor substrate is heated in a furnace to diffuse the dopant into the semiconductor substrate. However, heating in a furnace requires a high-temperature treatment for a long time and disadvantageously costs highly. Therefore, in recent years, a technique for diffusing a dopant into a semiconductor substrate from a dopant composition by laser irradiation is being aggressively developed.

For example, Patent Document 9 discloses that heating in an electric furnace or by laser irradiation can be utilized when diffusing a dopant by using a dopant composition containing a silicon compound such as silicon oxide.

Also, in Patent Document 10, for achieving dopant diffusion by laser irradiation, it is proposed to form a carbon-containing light-absorbing layer on a transparent substrate and put the light-absorbing layer into tight contact with a dopant composition layer. Furthermore, Non-Patent Document 1 proposes forming a silicon nitride layer for passivation and anti-reflection on a dopant composition layer and irradiating the silicon nitride film with a laser, thereby injecting a dopant into a semiconductor substrate.

[RELATED ART]

[Patent Document]

[Patent Document 1] JP-H2-163935-A
[Patent Document 2] JP2006-261681-A
[Patent Document 3] US7,704,866-B
[Patent Document 4] JP2010-519731-A
[Patent Document 5] JP2010-514585-A
[Patent Document 6] JP2006-80450-A
[Patent Document 7] JP2005-150609-A
[Patent Document 8] US7,923,368-B
[Patent Document 9] JP2012-019162-A
[Patent Document 10] JP2010-3834-A

[Non-Patent Document]

[Non-Patent Document 1] Laser process for selective emitter silicon solar cells (International Journal of Photoenergy, Volume 2012, 413863)

[SUMMARY OF THE INVENTION]

[Problems to be Solved by the Invention]

<<First Aspect of the Present invention>>

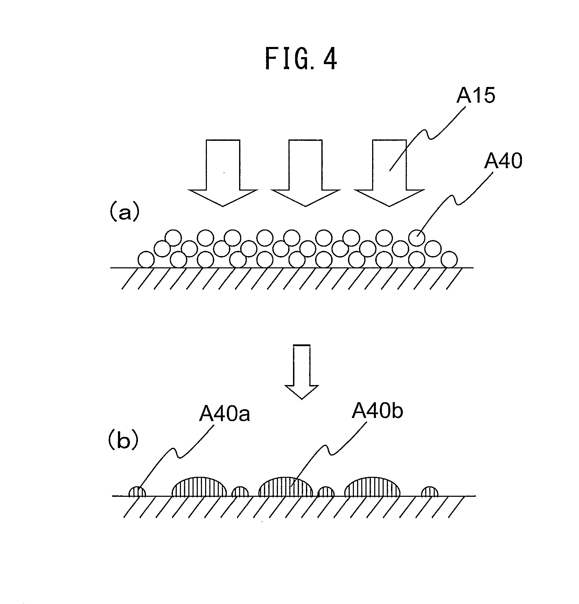

The silicon layer obtained by sintering silicon particles also preferably has a flat surface as described above, but such a silicon layer generally has a relatively large convex part on the surface. Specifically, as shown in Fig. 4, in the case of producing a semiconductor laminate by irradiating a silicon particle layer (A40) alone with light (Fig. 4(a)), the obtained silicon layer contains relatively small particles (A40a) and relatively large particles (A40b), which are produced by the sintering of particle, and the surface thereof has relatively large unevenness due to the relatively large particles (A40b) out of those particles. Also, the obtained silicon layer may lack sufficient continuity, because a portion where sintered particles are not in contact with each other may be produced.
As described above, in the manufacture of a semiconductor device, a silicon layer having a flat surface is required.
Accordingly, a first aspect of the present invention provides a semiconductor laminate comprising a substrate having formed thereon a silicon layer with small surface unevenness and high continuity, and a production method of such a semiconductor laminate. Also, the first aspect of the present invention provides a semiconductor laminate comprising a substrate having formed thereon a silicon layer with small surface unevenness and high continuity, wherein an insulating layer is further stacked on the silicon layer, and a production method of such a semiconductor laminate.

<<Second Aspect of the Present Invention>>

As described above, in the manufacture of a certain kind of a semiconductor device such as back-contact solar cell and PERL solar cell, a doped layer is formed in a selected region.
However, in conventional methods, as described above, a large number of steps are necessary for forming a doped layer in a selected region. Particularly, in the case where an n-type doped layer and a p-type doped layer must be formed as in a back-contact solar cell, a diffusion step has to be employed for each of the n-type doped layer and the p-typed doped layer, which requires a larger number of steps.
Furthermore, in the case of using photolithography as in conventional methods, only the process of boring a hole in the passivation layer requires many steps such as coating a photoresist, patterning by ultraviolet irradiation, forming a photoresist, removing an insulating layer, and removing the photoresist. Also in the case of using a laser, many steps such as forming a diffusion layer, forming a passivation layer, and boring a hole with a laser are necessary.

In addition, also in the case of forming a doped layer by using doped silicon particles as in Patent Document 8, removing a silicon particle-derived layer after the formation of doped layer must be employed.

In this regard, a second aspect of the present invention provides a method for manufacturing a semiconductor device, which is free from the above-described problems. Also, the second aspect of the present invention provides a semiconductor device obtained by the method of the second aspect of the present invention.

«Third Aspect of the Present Invention»

As described above, for example, in Patent Documents 9 and 10, use of a dopant composition containing a silicon compound such as silicon oxide or containing carbon is studied.

However, for example, in the dopant composition of Patent Document 9, the dopant composition containing a silicon compound such as silicon oxide does not absorb light and only the substrate absorbs light, leaving the possibility that the laser irradiation may cause damage to the substrate.

Also, in the method of Patent Document 10, the carbon used in the light-absorbing layer may diffuse into the substrate during laser irradiation and work out to an undesirable impurity.

The method of Non-Patent Document 1 requires CVD method or the like using high vacuum so as to deposit a silicon nitride layer for passivation or anti-reflection and has a problem of high cost.

Accordingly, a third aspect of the present invention provides a dopant composition free from the above-described problems.

Furthermore, the third aspect of the present invention provides a doped layer obtainable by using the dopant composition of the third aspect of the present invention, a method for forming a doped layer by using the dopant composition of the third aspect of the present invention, and a method for manufacturing a semiconductor device by using the doped layer forming method of the third aspect of the present invention.

[Means to Solve the Problems]

As a result of intensive studies, the present inventors have achieved the first aspect of the present invention including the following <A1> to <A22>.

<A1> A method for producing a semiconductor laminate having a substrate and a sintered silicon particle layer on the substrate, comprising:

(a) coating a silicon particle dispersion containing a dispersion medium and silicon particles dispersed in the dispersion medium, on a substrate to form a silicon particle dispersion layer,
(b) drying the silicon particle dispersion layer to form a green silicon particle layer,
(c) stacking a light-transmitting layer on the green silicon particle layer, and
(d) irradiating the green silicon particle layer with light through the light-transmitting layer to sinter the silicon particles constituting the green silicon particle layer, and thereby form a sintered silicon particle layer.

<A2> The method according to item <A1>> above, wherein the light-transmitting layer is retained after the light irradiation of the step (d).
<A3> The method according to item <A1> above, wherein the light-transmitting layer is removed by the light irradiation of the step (d).
<A4> The method according to any one of items <A1> to <A3> above, wherein the light-transmitting layer contains any one of an organic compound, an inorganic compound and an organic-inorganic hybrid compound.
<A5> The method according to any one of items <A1> to <A4> above, wherein the light-transmitting layer contains a silicon compound.
<A6> The method according to any one of items <A1> to <A5> above, wherein the light-transmitting layer contains silicon oxide or a compound having a siloxane bond.
<A7> The method according to any one of items <A1> to <A6> above, wherein the light-transmitting layer is formed of spin-on-glass.
<A8> The method according to any one of items <A1> to <A7> above, wherein the light-transmitting layer is formed by a liquid phase process.
<A9> The method according to any one of items <A1> to <A8> above, wherein the light-transmitting layer has a

volume resistivity of $10^{12}$ $\Omega\cdot$cm or more.

<A10> The method according to any one of items <A1> to <A9> above, wherein the light-transmitting layer has a film thickness of 50 to 1,000 nm.

<A11> The method according to any one of items <A1> to <A10> above, wherein the sintered silicon particle layer has a film thickness of 50 to 500 nm.

<A12> The method according to any one of items <A1> to <A11> above, wherein the light irradiation is performed using a laser.

<A13> The method according to item <A12> above, wherein the wavelength of the laser is 600 nm or less.

<A14> The method according to any one of items <A1> to <A13> above, wherein the light irradiation is performed in a non-oxidizing atmosphere.

<A15> The method according to any one of items <A1> to <A13> above, wherein the light irradiation is performed in an atmospheric atmosphere.

<A16> A semiconductor laminate having a substrate and a sintered silicon particle layer on the substrate, which is produced by the method of any one of items <A1> to <A15> above.

<A17> A semiconductor device comprising the semiconductor laminate according to item <A16> above.

<A18> A method for manufacturing a top-gate top-contact thin-film transistor, comprising producing a semiconductor laminate having a substrate and a sintered silicon particle layer on the substrate by the method of item <A2> above, removing a part of the light-transmitting layer from the semiconductor laminate to form an opening part reaching the sintered silicon particle layer, providing the opening parts with a source electrode and a drain electrode, and forming a gate electrode on the light-transmitting layer.

<A19> A top-gate top-contact thin-film transistor manufactured by the method of item <A18> above.

<A20> A green silicon laminate, comprising:

    (a) a substrate,
    (b) a green silicon particle layer stacked on the substrate and formed of silicon particles, and
    (c) a light-transmitting layer stacked on the green silicon particle layer.

<A21> A semiconductor laminate, comprising:

    (a) a substrate,
    (b) a sintered silicon particle layer stacked on the substrate and formed of silicon particles, and
    (c) a light-transmitting layer stacked on the sintered silicon particle layer.

<A22> A semiconductor laminate, comprising:

    (a) a glass substrate, and
    (b) a sintered silicon particle layer stacked directly on the glass substrate and formed of silicon particles, the sintered silicon particle layer having an arithmetic mean roughness of 100 nm or less.

As a result of intensive studies, the present inventors have achieved the second aspect of the present invention including the following <B1> to <B17>.

<B1> A method for manufacturing a semiconductor device, comprising forming a first doped layer in a first region of a semiconductor layer or substrate by the following steps:

    providing a laminate having the following (i) and (ii): (i) first and/or second passivation layers disposed on the semiconductor layer or substrate, and (ii) a first dopant injection layer disposed in the region corresponding to the first region above the first passivation layer but below the second passivation layer, in which the dopant injection layer is composed of first particles and the first particles are substantially formed of the same element as the semiconductor layer or substrate and is doped with a p-type or n-type dopant, and
    irradiating the region corresponding to the first dopant injection layer of the laminate with light, thereby doping the first region with the p-type or n-type dopant to form the first doped layer and at least partially removing the region corresponding to the dopant injection layer out of the first dopant injection layer and the passivation layer.

<B2> The method according to item <B1> above, comprising the following steps:

    depositing the first passivation layer on the semiconductor layer or substrate,
    applying a first dispersion containing first particles to, out of the first passivation layer, the region corresponding to the first region, the first particles being substantially formed of the same element as the semiconductor layer or substrate and being doped with a p-type or n-type dopant,

drying the first dispersion applied, thereby forming the first dopant injection layer, and

irradiating the first dopant injection layer with light, thereby doping the first region with the p-type or n-type dopant to form the first doped layer and at least partially removing the region corresponding to the first dopant injection layer out of the first dopant injection layer and the first passivation layer.

<B3> The method according to item <B1> above, comprising the following steps:

applying a first dispersion containing first particles to the first region, the first particles being substantially formed of the same element as the semiconductor layer or substrate and being doped with a p-type or n-type dopant,

drying the first dispersion applied, thereby forming the first dopant injection layer,

depositing the second passivation layer on the semiconductor layer or substrate and the first dopant injection layer, and

irradiating, out of the second passivation layer, the region corresponding to the first dopant injection layer with light, thereby doping the first region with the p-type or n-type dopant to form the first doped layer and at least partially removing the region corresponding to the first dopant injection layer out of the first dopant injection layer and the second passivation layer.

<B4> The method according to item <B1> above, comprising the following steps:

depositing the first passivation layer on the semiconductor layer or substrate,

applying a first dispersion containing first particles to, out of the first passivation layer, the region corresponding to the first region, the first particles being substantially formed of the same element as the semiconductor layer or substrate and being doped with a p-type or n-type dopant,

drying the first dispersion applied, thereby forming the first dopant injection layer,

depositing a second passivation layer on the first passivation layer and the first dopant injection layer, and

irradiating, out of the second passivation layer, the region corresponding to the first dopant injection layer with light, thereby doping the first region with the p-type or n-type dopant to form the first doped layer and at least partially removing the region corresponding to the first dopant injection layer out of the first dopant injection layer and the first and second passivation layers.

<B5> The method according to any one of items <B1> to <B4> above, further comprising forming an electrode through the passivation layer to come into contact with the first doped layer.

<B6> The method according to any one of items <B1> to <B5> above, wherein the concentration of the dopant is $1 \times 10^{17}$ atoms/cm$^3$ or more at a depth of 0.1 $\mu$m from the surface of the first region.

<B7> The method according to any one of items <B1> to <B6> above, wherein the passivation layer has a film thickness of 1 to 200 nm.

<B8> The method according to any one of items <B1> to <B7> above, wherein the passivation layer is formed of a material selected from the group consisting of SiN, $SiO_2$, $Al_2O_3$ and a combination thereof.

<B9> The method according to any one of items <B1> to <B8> above, wherein the semiconductor layer or substrate is a semiconductor layer or substrate of silicon, germanium or a combination thereof.

<B10> The method according to any one of items <B1> to <B9> above, wherein the dispersion is applied by a printing method.

<B11> The method according to any one of items <B1> to <B10> above, wherein the average primary particle diameter of the particles is 100 nm or less.

<B12> The method according to any one of items <B1> to <B11> above, further comprising forming a second doped layer in a second region of the semiconductor layer or substrate by the following steps:

applying a second dispersion containing second particles to a second region of the semiconductor layer or substrate, simultaneously with application of the first dispersion, between application and drying of the first dispersion, between drying of the first dispersion and removal of the first dopant injection layer, or after removal of the first dopant injection layer, the second particles being substantially formed of the same element as the semiconductor layer or substrate and being doped with a dopant of a type different from the dopant of the first particle,

drying the second dispersion applied, simultaneously with drying of the first dispersion or separately from drying of the first dispersion, thereby forming a second dopant injection layer, and

irradiating the second dopant injection layer with light, simultaneously with light irradiation of the first dopant injection layer or separately from light irradiation of the first dopant injection layer, thereby doping the second region with the p-type or n-type dopant to form the second doped layer and at least partially removing the region corresponding to the second dopant injection layer out of the second dopant injection layer and the first and/or second passivation layers.

<B13> The method according to item <B12> above, further comprising forming an electrode through the passivation layer to come into contact with the second doped layer.

<B14> The method according to item <B12> or <B13> above, wherein the semiconductor device is a solar cell.

<B15> A semiconductor device,

wherein a passivation layer is stacked on a semiconductor substrate or layer;

wherein, in a first region of the semiconductor substrate or layer, the passivation layer is at least partially removed, first particles are sintered to the semiconductor substrate or layer, and a first electrode reaching the first region through the passivation layer is formed via the first particle;

wherein the first particles are substantially formed of the same element as the semiconductor layer or substrate and is doped with a p-type or n-type dopant; and

wherein the concentration of the dopant is $1 \times 10^{17}$ atoms/cm$^3$ or more at a depth of 0.1 $\mu$m from the surface of the first region.

<B16> The semiconductor device according to item <B15> above,

wherein, in a second region of the semiconductor substrate or layer, the passivation layer is at least partially removed, second particles are sintered to the semiconductor substrate or layer, and a second electrode reaching the second region through the passivation layer is formed via the second particle;

wherein the second particles are substantially formed of the same element as the semiconductor layer or substrate and is doped with a dopant of a type different from the dopant of the first particle; and

wherein the concentration of the dopant is $1 \times 10^{17}$ atoms/cm$^3$ or more at a depth of 0.1 $\mu$m from the surface of the second region.

<B17> The semiconductor device according to item <B15> or <B16> above, which is a solar cell.

As a result of intensive studies, the present inventors have achieved the third aspect of the present invention including the following <C1> to <C20>.

<C1> A dopant composition, comprising:

a solvent,

a dopant compound having a dopant element, and

light-absorbing particles composed of a material having at least one peak absorption wavelength in the range of 100 to 1,000 nm.

<C2> The composition according to item <C1> above, wherein the light-absorbing particles are composed of silicon, germanium or a combination thereof.

<C3> The composition according to item <C1> or <C2> above, wherein the light-absorbing particles have an average primary particle diameter of 100 nm or less.

<C4> The composition according to any one of items <C1> to <C3> above, wherein the peak at the peak absorption wavelength is a maximum peak in the range of 200 to 2,500 nm.

<C5> The composition according to any one of items <C1> to <C4> above, wherein the light-absorbing particles contain substantially no dopant.

<C6> The composition according to any one of items <C1> to <C4> above, wherein the light-absorbing particles are doped with a dopant.

<C7> A dopant injection layer, comprising:

a dopant compound having a dopant element, and

light-absorbing particles composed of a material having at least one peak absorption wavelength in the range of 100 to 1,000 nm.

<C8> A dopant injection layer, comprising the following layers stacked one on another:

a dopant compound-containing layer containing a dopant compound having a dopant element, and

a light-absorbing particle-containing layer containing light-absorbing particles composed of a material having a peak absorption wavelength in the range of 100 to 1,000 nm.

<C9> The dopant injection layer according to item <C8> above, wherein the dopant compound-containing layer is stacked on the light-absorbing particle-containing layer.

<C10> The dopant injection layer according to item <C8> above, wherein the light-absorbing particle-containing layer is stacked on the dopant compound-containing layer.

<C11> The dopant injection layer according to any one of items <C8> to <C10> above, wherein the dopant compound-containing layer further contains light-absorbing particles composed of a material having a peak absorption wavelength in the range of 100 to 1,000 nm.

<C12> The dopant injection layer according to any one of items <C8> to <C11> above, wherein the light-absorbing particle-containing layer further contains a dopant compound having a dopant element.

<C13> The dopant injection layer according to any one of items <C7> to <C12> above, which is stacked on a semiconductor substrate.

<C14> The dopant injection layer according to item <C13> above, wherein the light-absorbing particles are composed of the same element as the semiconductor substrate.

<C15> A method for forming a doped layer, comprising irradiating the dopant injection layer according to item <C13> or <C14> above with light to diffuse the dopant element into the semiconductor substrate.

<C16> The method according to item <C15> above, wherein the light-absorbing particles have, at the main wavelength of the irradiated light, a light absorptivity of 0.1 times or more the light absorptivity at the peak absorption wavelength.

<C17> The method according to item <C15> or <C16> above, wherein the irradiated light is laser light.

<C18> A method for manufacturing a semiconductor device, comprising forming a doped layer by the method of any one of items <C15> to <C17> above.

<C19> The method according to item <C18> above, wherein the semiconductor device is a solar cell.

<C20> A semiconductor device manufactured by the method of item <C18> or <C19> above.

[Effects of the Invention]

According to the method of the first aspect of the present invention for producing a semiconductor laminate, the sintered silicon particle layer on the substrate can have a relatively flat surface and high continuity without an additional step of removing the surface unevenness. In the semiconductor laminate of the first aspect of the present invention, the sintered silicon particle layer can have a relatively flat surface and high continuity, so that when an insulating layer, an electrode or the like is deposited thereon, a semiconductor device having good properties can be obtained.

According to the method of the second aspect of the present invention, a doped layer (sometimes referred to as "diffusion layer") can be formed in a selected region through a relatively small number of steps, and the passivation layer in the region corresponding to the doped layer can be at least partially removed. In turn, according to the method of the second aspect of the present invention, a semiconductor device having a doped layer only in a selected region, for example, a solar cell, particularly a back-contact solar cell and a PERL solar cell, can be manufactured through a relatively small number of steps.

According to the dopant composition of the third aspect of the present invention, a dopant injection layer can be easily film-formed by coating, and a dopant can be effectively diffused into the substrate by irradiating the obtained dopant injection layer with light such as green laser (wavelength: 532 nm). In particular, according to the dopant composition of the third aspect of the present invention, in the case of using light-absorbing particles composed of the same element as the semiconductor substrate, an undesired impurity can be prevented from diffusing together with a dopant by not allowing the light-absorbing particles to contain such an undesired impurity.

[Brief Description of the Drawings]

[Fig. 1] Fig. 1 is a view for explaining the method of the first aspect of the present invention for producing a semiconductor laminate.

[Fig. 2] Fig. 2 is a view for explaining the method for manufacturing a top-gate top-contact TFT by using a semiconductor laminate obtained by the method of the first aspect of the present invention for producing a semiconductor laminate.

[Fig. 3] Fig. 3 is a view for explaining the method for producing a semiconductor laminate by irradiating an amorphous silicon layer with light.

[Fig. 4] Fig. 4 is a view for explaining the method for producing a semiconductor laminate by irradiating a green silicon particle layer alone with light.

[Fig. 5] Figs. 5(a) to (d) are respectively cross-sectional FE-SEM photographs of semiconductor laminates obtained in Examples A1-1 to A1-4.

[Fig. 6] Figs. 6(a) to (d) are respectively cross-sectional FE-SEM photographs of semiconductor laminates obtained in Examples A2-1 to A2-4.

[Fig. 7] Figs. 7(a) to (d) are respectively cross-sectional FE-SEM photographs of semiconductor laminates obtained in Comparative Examples A1 to 4.

[Fig. 8] Fig. 8 is a view for explaining a first embodiment of the method of the second aspect of the present invention, where a doped layer is formed in a part of a substrate.

[Fig. 9] Fig. 9 is a view for explaining a second embodiment of the method of the second aspect of the present invention, where a doped layer is formed in a part of a substrate.

[Fig. 10] Fig. 10 is a view for explaining a third embodiment of the method of the second aspect of the present invention, where a doped layer is formed in a part of a substrate.

[Fig. 11] Fig. 11 is a view for explaining an example of the back-contact solar cell.

[Fig. 12] Fig. 12 is a view for explaining an example of the PERL solar cell.

[Fig. 13] Fig. 13 is a view for explaining the conventional method where a doped layer is formed in a part of a substrate.

[Fig. 14] Fig. 14 is a view showing the results of dynamic secondary ion mass spectrometry (Dynamic SIMS) of the substrate produced in Example B1.

[Fig. 15] Fig. 15 is a view showing a field emission scanning electron microscopy (FE-SEM) photograph of the cross-section of the substrate produced in Example B1.

[Fig. 16] Fig. 16 is a graph showing the results of dynamic secondary ion mass spectrometry (Dynamic SIMS) of the substrate produced in Example B2.

[Fig. 17] Fig. 17 is a view conceptually showing light absorption by the dopant injection layer of the third aspect of the present invention (Figs. 17(a), (c) and (d)) and light absorption by the conventional dopant injection layer (Fig. 17(b)).

[Fig. 18] Fig. 18 is a graph showing light transmittance of the dopant injection layers used in Examples C1-1 to C1-3 and Comparative Example C1.

[Fig. 19] Fig. 19 is a graph showing light transmittance of the dopant injection layer used in Example C2.

[Fig. 20] Fig. 20 is a graph showing light transmittance of the dopant injection layer used in Example C3.

[Mode for Carrying Out the Invention]

<< <<First Aspect of the Present Invention>> >>

<<Production Method of Semiconductor Laminate>>

The method of the first aspect of the present invention for producing a semiconductor laminate having a substrate and a sintered silicon particle layer on the substrate comprises the following steps (a) to (d):

(a) coating a silicon particle dispersion containing a dispersion medium and silicon particles dispersed in the dispersion medium, on a substrate to form a silicon particle dispersion layer,
(b) drying the silicon particle dispersion layer to form a green silicon particle layer,
(c) stacking a light-transmitting layer on the green silicon particle layer, and
(d) irradiating the green silicon particle layer with light through the light-transmitting layer to sinter the silicon particles constituting the green silicon particle layer, and thereby form a sintered silicon particle layer.

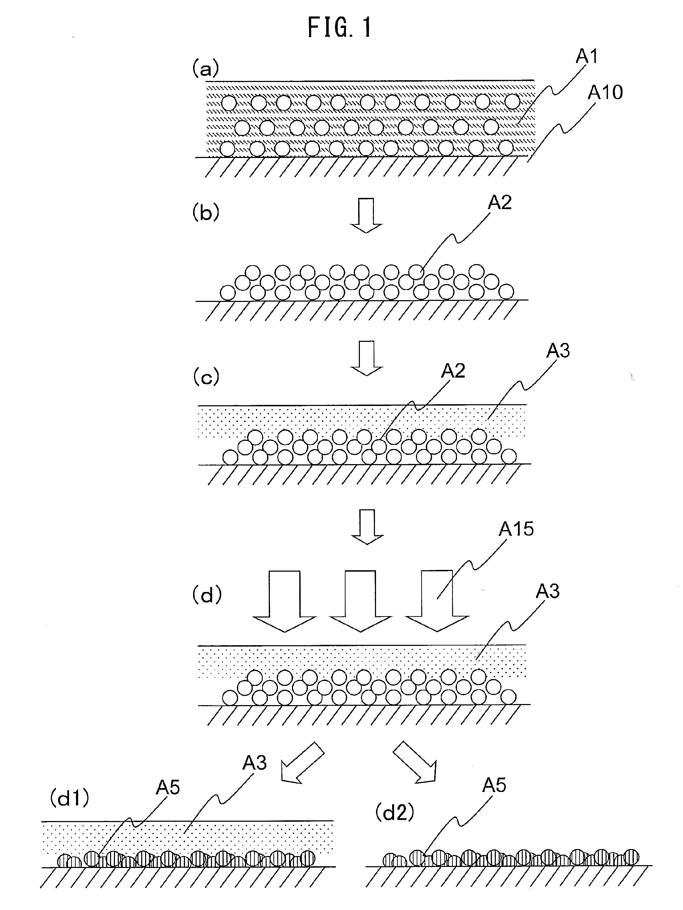

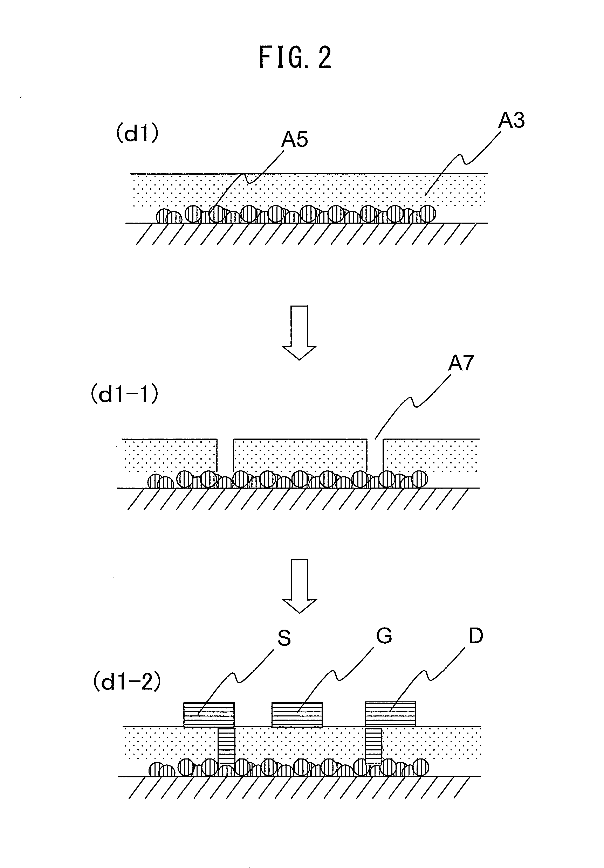

In the following, each step in the method of the first aspect of the present invention is described by referring to Fig. 1.

<<Production Method of Semiconductor Laminate - Step (a)>>

In the step (a) of the method of the first aspect of the present invention, at the beginning, a silicon particle dispersion containing a dispersion medium and silicon particles dispersed in the dispersion medium is coated on a substrate (A10) to form a silicon particle dispersion layer (A1) (see Fig. 1(a)).

(Particle)

The silicon particles contained in the silicon particle dispersion are not limited if it is particles composed of silicon, as long as the object and effects of the first aspect of the present invention are not impaired. As the silicon particles, silicon particles described, for example, in Patent Documents 4 and 5 may be used. Specifically, the silicon particles include silicon particles obtained by a laser pyrolysis process, particularly, a laser pyrolysis process using a $CO_2$ laser.

The particles of the dispersion may preferably have a relatively small particle diameter so as to form a semiconductor laminate having a flat surface by melting and sintering the particles through light irradiation.

For example, the average primary particle diameter of the particles may be 1 nm or more, 3 nm or more, 5 nm or more, 10 nm or more, or 15 nm or more. Also, the average primary particle diameter of the particles may be 100 nm or less, 40 nm or less, 30 nm or less, 20 nm or less, or 10 nm or less.

In the first aspect of the present invention, the average primary particle diameter of the present invention can be determined as the number average primary particle diameter by directly measuring the particle diameter based on an image photographed on observation by a Scanning Electron Microscope (SEM), a Transmission Electron Microscope (TEM) or the like, and analyzing particles with an aggregation number of 100 or more.

The silicon particles may be doped with a p-type or n-type dopant. The p-type or n-type dopant is selected, for example, from the group consisting of boron (B), aluminum (Al), gallium (Ga), indium (In), titanium (Ti), phosphorus (P), arsenic (As), antimony (Sb) and a combination thereof.

In the case of using the sintered silicon particle layer as the dopant injection layer, the degree to which the silicon particles is doped can be determined depending on the desired dopant concentration or the like in the sintered silicon particle layer as the dopant injection layer and in the substrate. Specifically, for example, the particles can contain the dopant at a concentration of $1\times10^{18}$ atoms/cm$^3$ or more, $1\times10^{19}$ atoms/cm$^3$ or more, $1\times10^{20}$ atoms/cm$^3$ or more, $5\times10^{20}$ atoms/cm$^3$ or more, or $1\times10^{21}$ atoms/cm$^3$ or more.

(Dispersion Medium)

The dispersion medium of the dispersion is not limited as long as the object and effects of the first aspect of the present invention are not impaired, and, for example, an organic solvent incapable of reacting with the silicon particles for use in the first aspect of the present invention can be used. Specifically, the dispersion medium may be a non-aqueous solvent, for example, an alcohol, an alkane, an alkene, an alkyne, a ketone, an ether, an ester, an aromatic compound or a nitrogen-containing ring compound, particularly, isopropyl alcohol (IPA), N-methyl-2-pyrrolidone (NMP), terpineol or the like. As the alcohol, a glycol (dihydric alcohol) such as ethylene glycol may also be used. Incidentally, in order to suppress oxidation of the particles for use in the first aspect of the present invention, the dispersion medium is preferably a dehydrated solvent.

(Substrate)

The substrate for use in the method of the first aspect of the present invention is not limited as long as the object and effects of the first aspect of the present invention are not impaired. For example, a silicon substrate, a glass substrate or a polymer substrate can be used as the substrate. According to the first aspect of the present invention, a sintered silicon particle layer having a relatively flat surface and high continuity can be obtained even on a substrate, especially on a glass substrate, where a sintered silicon particle layer having a flat surface and high continuity can be hardly obtained.

(Silicon particle dispersion Layer)

The thickness of the silicon particle dispersion layer obtained in the step (a) can be arbitrarily determined according to the thickness of the sintered silicon particle layer that is desired to be finally obtained.

<<Production Method of Semiconductor Laminate - Step (b)>>

In the step (b) of the method of the first aspect of the present invention, the silicon particle dispersion layer 1 is dried to form a green silicon particle layer (A2) (see Fig. 1(b)).

The green silicon particle layer may be a single layer or may be formed by stacking a plurality of layers. For example, the green silicon particle layer of the step (b) may be a laminate obtained by stacking, in order, a green silicon particle layer containing a p-type dopant, a green silicon particle layer containing substantially no dopant, and a green silicon particle layer containing an n-type dopant, and in this case, a sintered silicon particle layer having a p-i-n structure can be obtained at a time by sintering the laminate.

<Drying>

The drying is not particularly limited if it is a method capable of substantially removing the dispersion medium from the dispersion, and, for example, the drying may be performed by placing the substrate with the dispersion on a hot plate or in a heating atmosphere.

The drying temperature can be selected, for example, so as not to cause deterioration or the like of the substrate or the particles of the dispersion and may be selected to be, for example, 50°C or more, 70°C or more, or 90°C or more, and be 100°C or less, 150°C or less, 200°C or less, or 250°C or less.

<<Production Method of Semiconductor Laminate - Step (c) >>

In the step (c) of the method of the first aspect of the present invention, a light-transmitting layer (A3) is stacked on the green silicon particle layer (A2) (see Fig. 1(c)).

As regards the first aspect of the present invention, the light-transmitting layer may be any layer enabling the green silicon particle layer to be irradiated with light through the light-transmitting layer during light irradiation in the step (d). For example, the light-transmitting layer is a layer where the transmittance for the irradiated light in the step (d), that is, the ratio of light flux of transmitted light to the incident light, is 80% or more, 85% or more, 90% or more, 95% or more, 98% or more, or 99% or more. Also, for example, the light-transmitting layer is a layer where the total light transmittance measured in conformity with JIS K7361-1 has such a value.

The material and properties such as thickness of the light-transmitting layer are not limited as long as the object and effects of the first aspect of the present invention are not impaired, and these can be determined based on the transmittance for irradiated light in the step (d), the ability to flatten the sintered silicon particle layer, and the properties of this layer desired to remain in the obtained semiconductor laminate.

The material of such a light-transmitting layer may be any of an organic compound, an inorganic compound and an organic-inorganic hybrid compound and particularly, may be a silicon compound. The silicon compound includes silicon oxide, silicon nitride, and a compound having a siloxane bond.

For stacking the light-transmitting layer on the green silicon particle layer, any method such as gas phase method and liquid phase method can be used. The gas phase method specifically includes a chemical vapor deposition method (CVD) and a physical vapor deposition method (PVD), and the liquid phase method includes a solution method.

The light-transmitting layer may be a so-called spin-on-glass (SOG) layer. In the formation of such a spin-on-glass layer, usually, an organosilicon compound is mixed with a solvent to form a spin-on-glass solution, the solution is applied to a substrate by spin coating or the like, and thereafter, the organosilicon compound is dehydrated and condensed by heating. The organosilicon compound that can be used for the formation of the spin-on-glass layer includes an alkoxysilane, a silanol, a siloxane, a silicate and the like.

The material of the light-transmitting layer may have a volume resistivity of, for example, $10^{10}$ Ω·cm or more, $10^{11}$ Ω·cm or more, $10^{12}$ Ω·cm or more, $10^{13}$ Ω·cm or more, or $10^{14}$ Ω·cm or more. For using the light-transmitting layer as an insulating layer when the layer is retained after light irradiation of the step (d), it is preferred that the material of the light-transmitting layer has a large volume resistivity.

The thickness of the light-transmitting layer may be, for example, 50 nm or more, 100 nm or more, 200 nm or more, or 300 nm or more, and 1,000 nm or less, 900 nm or less, 800 nm or less, or 700 nm or less.

<<Production Method of Semiconductor Laminate - Step (d)>>

In the step (d) of the method of the first aspect of the present invention, the green silicon particle layer (A2) is irradiated with light (A15) through the light-transmitting layer (A3) to sinter the silicon particles constituting the green silicon particle layer (A2), and thereby form a sintered silicon particle layer (A5) (see Figs. 1(d), (d1) and (d2)).

As described above, the light-transmitting layer is a layer that substantially transmits the irradiated light. Therefore, when the green silicon particle layer is irradiated with light, the substantial portion of irradiated light is transmitted by the light-transmitting layer and reaches the green silicon particle layer, whereby the silicon particles can be sintered.

The light-transmitting layer stacked in the step (c) may be retained after light irradiation of the step (d) (see Fig. 1(d1)) or may be removed by light irradiation of the step (d) (see Fig. 1(d2)).

In the case of manufacturing a semiconductor device by using the sintered silicon particle layer as a semiconductor layer and using the light-transmitting layer as an insulating layer, it may be preferred that the light-transmitting layer is retained after light irradiation of the step (d). However, even when the light-transmitting layer is retained after light irradiation of the step (d), the light-transmitting layer may be partially or completely removed to expose the sintered silicon particle layer.

For example, in the case where the light-transmitting layer is retained after light irradiation of the step (d), a top-gate top-contact thin transistor can be manufactured by producing a semiconductor laminate having a substrate and a sintered silicon particle layer on the substrate by the method of the first aspect of the present invention, then removing a part of the light-transmitting layer from the semiconductor laminate to form an opening part (A7) reaching the sintered silicon particle layer, providing the opening parts (A7) with a source electrode S and a drain electrode D, and forming a gate electrode G on the light-transmitting layer (see Fig. 2(d1-1)).

Also, for example, in the case where the light-transmitting layer is retained after light irradiation of the step (d), an electrode reaching the sintered silicon particle layer can be formed by producing a semiconductor laminate having a substrate and a sintered silicon particle layer on the substrate by the method of the first aspect of the present invention, then forming an electrode on the light-transmitting layer, and applying a so-called fire-through technique of causing the electrode to penetrate the light-transmitting layer by heating. Such a configuration can be used in a solar cell.

It may be sometimes preferred that the light-transmitting layer is removed by light irradiation of the step (d), because the later step of removing the light-transmitting layer can be made unnecessary. Also, in the case where the light-transmitting layer is removed by light irradiation of the step (d), another layer can be optionally stacked on the sintered silicon particle layer.

The sintered silicon particle layer obtained after light irradiation of the step (d) may have any thickness according to the intended use and may have, for example, a film thickness of 50 nm or more, 100 nm or more, or 200 nm or more, and 1,000 nm or less, 800 nm or less, 500 nm or less, or 300 nm or less.

(Irradiated Light)

As the irradiated light, any light can be used if formation of the above-described sintered silicon particle layer can be achieved.

For example, laser light composed of a single wavelength, particularly, laser light having a wavelength of 800 nm or less, 700 nm or less, 600 nm or less, 500 nm or less, or 400 nm or less, and 300 nm or more, can be used as the irradiated light. In addition, irradiation of the green silicon particle layer with light can also be performed using a flash lamp such as xenon flash lamp that emits light in the wavelength range of a specific band (for example, from 200 to 1,100 nm) at a time. Furthermore, light such as pulsed light and continuously oscillating light can be optionally used if formation of the above-described sintered silicon particle layer can be achieved.

For example, in the case of performing the light irradiation by using pulsed light, the number of pulsed light irradiations may be 1 or more, 2 or more, 5 or more, or 10 or more, and 300 or less, 200 or less, or 150 or less. Also, the irradiation energy of pulsed light may be, for example, 15 mJ/ (cm$^2$·shot) or more, 50 mJ/(cm$^2$·shot) or more, 100 mJ/(cm$^2$·shot) or more, 200 mJ/(cm$^2$·shot) or more, 300 mJ/(cm$^2$·shot) or more, 350 mJ/(cm$^2$·shot) or more, 400 mJ/(cm$^2$·shot) or more, 500 mJ/(cm$^2$·shot) or more, 600 mJ/(cm$^2$·shot) or more, or 700 mJ/(cm$^2$·shot) or more. In addition, the irradiation energy may be 5,000 mJ/(cm$^2$·shot) or less, 4,000 mJ/(cm$^2$·shot) or less, 3,000 mJ/(cm$^2$·shot) or less, 2,000 mJ/(cm$^2$·shot) or less, 1,500 mJ/(cm$^2$·shot) or less, 1,000 mJ/(cm$^2$·shot) or less, 800 mJ/(cm$^2$·shot) or less, or 600 mJ/(cm$^2$·shot) or less. Furthermore, the irradiation time of pulsed light may be, for example, 200 nanoseconds/shot or less, 100 nanoseconds/shot or less, or 50 nanoseconds/shot or less.

If the number of light irradiations is too small, the energy per pulse required to achieve the desired sintering becomes large, posing a risk that the sintered silicon particle layer is damaged. Also, if the irradiation energy per pulse is too small, the silicon particles may fail to reach the sintering temperature. Even when the sintering temperature is attained, if the energy is too small, the number of irradiations necessary for obtaining the required cumulative energy is increased, and therefore the processing time may be prolonged. Incidentally, the optimal conditions such as irradiation energy and number of irradiations are dependent on, for example, the wavelength of light irradiation used or the properties of particle, and one skilled in the art can determine the optimal value by performing an experiment with reference to the description of the present invention.

(Irradiation Atmosphere)

The light irradiation for sintering the dispersion particles is preferably performed in a non-oxidizing atmosphere, for example, an atmosphere composed of hydrogen, a rare gas, nitrogen or a combination thereof, so as to prevent oxidation of the dispersion particle. However, in the method of the first aspect of the present invention, a light-transmitting layer is stacked on the green silicon particle layer and since the green silicon particle layer is thereby isolated from the atmosphere, the light irradiation can also be performed in an oxidizing atmosphere such as atmospheric atmosphere. The rare gas includes, particularly argon, helium and neon. Incidentally, hydrogen has an action of reducing the dispersion particles and for forming a continuous layer by reducing the oxidized surface portion, it may be preferred that the atmosphere contains hydrogen. In order to create a non-oxidizing atmosphere, the oxygen content in the atmosphere may be 1 vol% or less, 0.5 vol% or less, 0.1 vol% or less, or 0.01 vol% or less.

<<Semiconductor Laminate and Green Silicon Laminate>>

The semiconductor laminate of the first aspect of the present invention has a substrate and a sintered silicon particle layer on the substrate and is produced by the method of the first aspect of the present invention.

The semiconductor laminate of the first aspect of the present invention has, for example, (a) a substrate, (b) a sintered silicon particle layer stacked on the substrate and formed of silicon particles, and (c) a light-transmitting layer stacked on the sintered silicon particle layer.

Also, the semiconductor laminate of the first aspect of the present invention has, for example, (a) a glass substrate and (b) a sintered silicon particle layer stacked directly on the glass substrate and formed of silicon particles, the sintered silicon particle layer having an arithmetic mean roughness of 100 nm or less, 90 nm or less, 80 nm or less, 70 nm or less, 60 nm or less, 50 nm or less, or 40 nm or less.

Incidentally, as regards the present invention, the arithmetic mean roughness (centerline average roughness) (Ra) is defined in conformity with JIS B0601-1994. Specifically, when a portion of reference length 1 (1,000$\mu$ m) is extracted from a roughness curve in its centerline direction and the roughness curve is expressed by y=f(x) by assigning the centerline of the extracted portion to X axis and the longitudinal magnification direction to Y axis, the arithmetic mean roughness (Ra) is represented by the following formula:

[Math. 1]

$$R_a = \frac{1}{l} \int_0^1 |f(x)| dx$$

For producing the semiconductor of the present invention in this way, the green silicon laminate of the first aspect of the present invention may be irradiated with light. Here, the green silicon laminate of the first aspect of the present invention may have (a) a substrate, (b) a green silicon particle layer stacked on the substrate and formed of silicon particles, and (c) a light-transmitting layer stacked on the green silicon particle layer.

<<Semiconductor Device>>

The semiconductor device of the first aspect of the present invention has the semiconductor laminate of the first aspect of the present invention. In the case where the semiconductor device of the first aspect of the present invention is a field-effect transistor such as top-gate top-contact thin-film transistor or a solar cell, by virtue of having a silicon layer with small surface unevenness and high continuity, stable properties can be provided when an insulating layer, an electrode or the like is deposited on the silicon layer.

<< <<Second Aspect of the Present Invention>> >>

<<Manufacturing Method of Semiconductor Device>>

The method of the second aspect of the present invention for manufacturing a semiconductor device comprises forming a first doped layer in a first region of a semiconductor layer or substrate by the following steps.

That is, in the method of the second aspect of the present invention, at the beginning, a laminate having the following (i) and (ii) is provided: (i) first and/or second passivation layers disposed on the semiconductor layer or substrate, and (ii) a first dopant injection layer disposed in the region corresponding to the first region above the first passivation layer but below the second passivation layer, in which the dopant injection layer is composed of first particles and the first particles are substantially formed of the same element as the semiconductor layer or substrate and is doped with a p-type or n-type dopant.

Next, in the method of the second aspect of the present invention, the region corresponding to the first dopant injection layer of the laminate is irradiated with light, thereby doping the first region with the p-type or n-type dopant to form the first doped layer and at least partially removing the region corresponding to the dopant injection layer out of the first dopant injection layer and the passivation layer.

In the method of the second aspect of the present invention, the concentration of the dopant at a depth of 0.1 $\mu$m from the surface of said first region may be $1\times10^{17}$ atoms/cm$^3$ or more, $1\times10^{18}$ atoms/cm$^3$ or more, $1\times10^{19}$ atoms/cm$^3$ or more, or $1\times10^{20}$ atoms/cm$^3$ or more.

The semiconductor device manufactured by the method of the second aspect of the present invention may be a solar cell or a thin-layer transistor. Also, the solar cell may be a back-contact solar cell or a PERL solar cell, and the first region may be on the back surface side of the semiconductor layer or substrate.

<First Embodiment>

The first embodiment of the method of the second aspect of the present invention comprises the following steps:

depositing a first passivation layer on a semiconductor layer or substrate,
applying a first dispersion containing first particles to, out of the first passivation layer, the region corresponding to a first region, the first particles being substantially formed of the same element as the semiconductor layer or substrate and being doped with a p-type or n-type dopant,
drying the first dispersion applied, thereby forming a first dopant injection layer, and
irradiating the first dopant injection layer with light, thereby doping the first region with the p-type or n-type dopant to form a first doped layer and at least partially removing the region corresponding to the first dopant injection layer out of the first dopant injection layer and the first passivation layer.

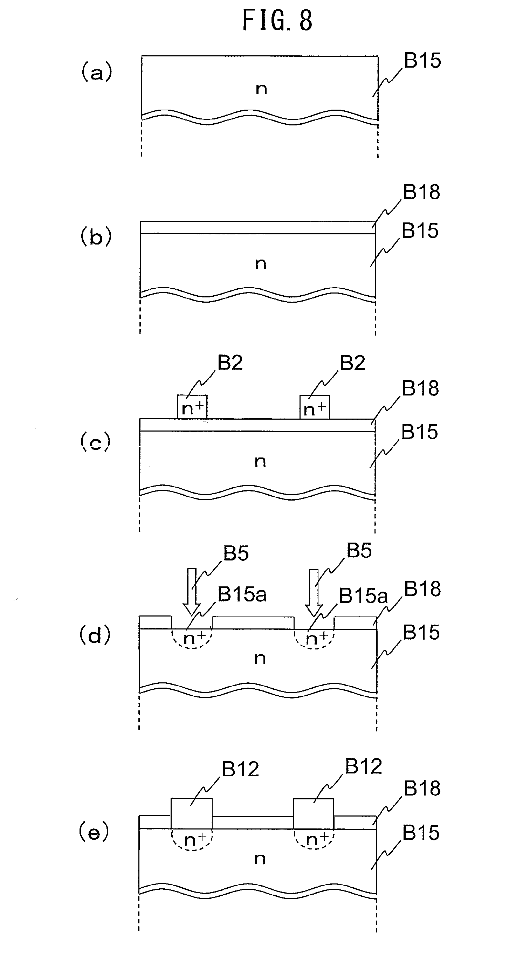

More specifically, for example, in the case of forming a first doped layer in a first region according to the first embodiment of the method of the second aspect of the present invention, as shown in Fig. 8, a passivation layer (B18) is deposited on a semiconductor substrate (B15) (Figs. 8(a) and (b)), a first dispersion containing first particles is applied to the region corresponding to the first region of the first passivation layer (B18), the dispersion is dried to form a first dopant injection layer (B2) (Fig. 8(c)), the first dopant injection layer (B2) is irradiated with light (B5), thereby doping the first region with a p-type or n-type dopant to form a first doped layer (B15a) and at least partially removing the region corresponding to the first dopant injection layer (B2) out of the first dopant injection layer (B2) and the first passivation layer (B18) (Fig. 8(d)), and an electrode (B12) is optionally formed through the passivation layer (B18) to come into contact with the first doped layer (B15a) (Fig. 8(e)).

Also, in the case where both an n-type doped layer and a p-type doped layer must be formed as in a back-contact solar cell, a second dispersion containing second particles is applied to a second region of the semiconductor layer or substrate, simultaneously with application of the first dispersion, between application and drying of the first dispersion, between drying of the first dispersion and removal of the first dopant injection layer, or after removal of the first dopant injection layer.

Thereafter, the second dispersion applied is dried simultaneously with drying of the first dispersion or separately from drying of the first dispersion, thereby forming a second dopant injection layer, and the second dopant injection layer is irradiated with light simultaneously with light irradiation of the first dopant injection layer or separately from light irradiation of the first dopant injection layer, thereby doping the second region of the semiconductor layer or substrate with the p-type or n-type dopant to form the second doped layer and at least partially removing the region corresponding to the second dopant injection layer out of the second dopant injection layer and the first and/or second passivation layers.

More specifically, in the case where both an n-type doped layer and a p-type doped layer must be formed, in the method of the second aspect of the present invention, the particles doped with a p-type dopant and the particles doped with an n-type dopant can be collectively sintered by light irradiation or collectively sintered by drying and light irradiation. Such a processing may be beneficial to the shortening of production process. In this case, a processing of performing application of the dispersion by using a printing method such as inkjet printing and screen printing without using photolithography may be particularly beneficial to the shortening of production process.

Furthermore, in the case where both an n-type doped layer and a p-type doped layer must be formed, in the method of the second aspect of the present invention, it is also possible to repeat the method of the second aspect of the present invention for each of the n-type doped layer and the p-type doped layer.

Incidentally, the second particles are substantially formed of the same element as the semiconductor layer or substrate, and are doped with a dopant of a type different from the dopant of the first particle. In addition, as for the second doped layer, the description of the present invention regarding the first doped layer may be referred to, and in particular, as for the production method of the second dopant injection layer, the doping concentration and the like, the description of the present invention regarding the first dopant injection layer may be referred to.

<Second Embodiment>

The second embodiment of the method of the second aspect of the present invention comprises the following steps:

applying a first dispersion containing first particles to a first region, the first particles being substantially formed of the same element as a semiconductor layer or substrate and being doped with a p-type or n-type dopant,
drying the first dispersion applied, thereby forming a first dopant injection layer,

depositing a second passivation layer on the semiconductor layer or substrate and the first dopant injection layer, and irradiating, out of the second passivation layer, the region corresponding to the first dopant injection layer with light, thereby doping the first region with the p-type or n-type dopant to form a first doped layer and at least partially removing the region corresponding to the first dopant injection layer out of the first dopant injection layer and the second passivation layer.

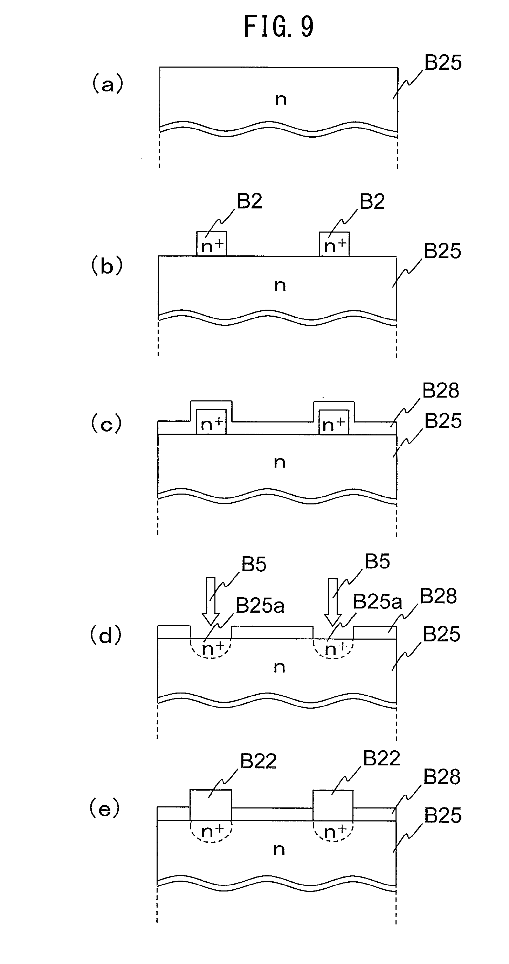

More specifically, for example, in the case of forming a first doped layer in a first region according to the second embodiment of the method of the second aspect of the present invention, as shown in Fig. 9, a first dispersion containing first particles is applied to the first region of the semiconductor substrate (B25), the dispersion is dried to form a first dopant injection layer (B2) (Figs. 9(a) and (b)), a second passivation layer (B28) is deposited on the first dopant injection layer (B2) (Fig. 9(c)), the region corresponding to the first dopant injection layer (B2) of the second passivation layer (B28) is irradiated with light (B5), thereby doping the first region of the semiconductor substrate with a p-type or n-type dopant to form a first doped layer (B25a) and at least partially removing the region corresponding to the first dopant injection layer (B2) out of the first dopant injection layer (B2) and the second passivation layer (B28) (Fig. 9(d)), and an electrode (B22) is optionally formed through the second passivation layer (B28) to come into contact with the first doped layer (B25a) (Fig. 9(e)).

Also, in the case where both an n-type doped layer and a p-type doped layer must be formed as in a back-contact solar cell, as described in the first embodiment above, the second region of the semiconductor substrate can be doped with a p-type or n-type dopant by using the second dispersion.

<Third Embodiment>

The third embodiment of the method of the second aspect of the present invention comprises the following steps:

depositing a first passivation layer on a semiconductor layer or substrate,
applying a first dispersion containing first particles to, out of the first passivation layer, the region corresponding to a first region, the first particles being substantially formed of the same element as the semiconductor layer or substrate and being doped with a p-type or n-type dopant,
drying the first dispersion applied, thereby forming a first dopant injection layer,
depositing a second passivation layer on the first passivation layer and the first dopant injection layer, and
irradiating, out of the second passivation layer, the region corresponding to the first dopant injection layer with light, thereby doping the first region with the p-type or n-type dopant to form a first doped layer and at least partially removing the region corresponding to the first dopant injection layer out of the first dopant injection layer and the first and second passivation layers.

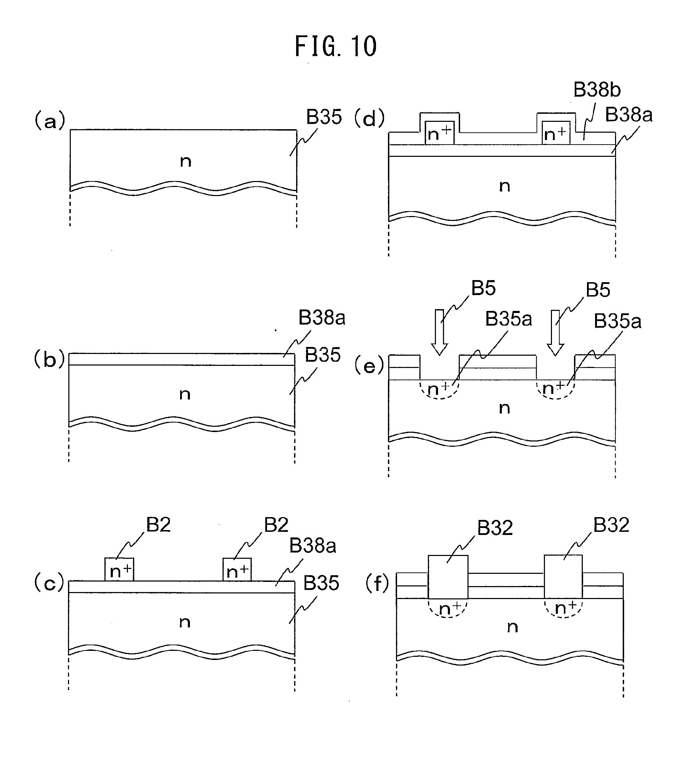

More specifically, for example, in the case of forming a first doped layer in a first region according to the third embodiment of the method of the second aspect of the present invention, as shown in Fig. 10, a first passivation layer (B38a) is deposited on a semiconductor substrate (B35) (Figs. 10(a) and (b)), a first dispersion containing first particles is applied to the region corresponding to the first region out of the first passivation layer (B38a), the dispersion is dried to form a first dopant injection layer (B2) (Fig. 10(c)), a second passivation layer (B38b) is deposited on the first passivation layer (B38a) and the first dopant injection layer (2) (Fig. 10(d)), the region corresponding to the first dopant injection layer (B2) out of the second passivation layer (B38b) is irradiated with light (B5), thereby doping the first region of the semiconductor substrate with a p-type or n-type dopant to form a first doped layer (B35a) and at least partially removing the region corresponding to the first doped layer (B35a) out of the first dopant injection layer (B2) and the first and second passivation layers (B38a, B38b) (Fig. 10(e)), and an electrode (B32) is optionally formed through the first and second passivation layers (B38a, B38b) to come into contact with the first doped layer (B35a) (Fig. 10(f)).

Also, in the case where both an n-type doped layer and a p-type doped layer must be formed as in a back-contact solar cell, as described in the first embodiment above, the second region of the semiconductor substrate can be doped with a p-type or n-type dopant by using the second dispersion.

<Semiconductor Layer and Substrate>

As the semiconductor layer or substrate that can be used in the second aspect of the present invention, any semiconductor layer or substrate composed of a semiconductor element may be employed. Here, silicon, germanium, or a combination thereof may be used as the semiconductor element. Accordingly, the semiconductor layer or substrate includes a silicon wafer, a gallium wafer, an amorphous silicon layer, an amorphous gallium layer, a crystalline silicon layer, and a crystalline gallium layer.

In addition, the semiconductor layer or substrate may be doped with the same dopant element as that of the particles contained in the dispersion, at a concentration lower than in the particle. Furthermore, the semiconductor layer or substrate may be entirely or partially doped in advance.

<Passivation Layer>

The passivation layer that can be used in the method of the second aspect of the present invention may have any thickness enabling the layer to function as a passivation layer, and the thickness may be, for example, 1 nm or more, 5 nm or more, 10 nm or more, 30 nm or more, or 50 nm or more. Also, the thickness may be 300 nm or less, 200 nm or less, 100 nm or less, 50 nm or less, 30 nm or less, 20 nm or less, or 10 nm or less. If the thickness is too small, the property as the passivation layer may be poor, or if the thickness is too large, the layer may not be removed by light irradiation. In particular, when the passivation layer is a first passivation layer, that is, in the case of depositing a dopant injection layer on the passivation layer and not only forming a first doped layer by doping the first region with a dopant through light irradiation but also removing the dopant injection layer and the region corresponding to the dopant injection layer of the passivation layer, if the thickness of the passivation layer is too large, injection of the dopant into the semiconductor layer or substrate may become insufficient.

The passivation layer may be formed of any material enabling the layer to function as a passivation layer and may be formed, for example, a material selected from the group consisting of silicon nitride (SiN), silicon oxide ($SiO_2$), aluminum oxide ($Al_2O_3$) and a combination thereof.

<Dispersion>

Application of the dispersion in the method of the second aspect of the present invention for manufacturing a semiconductor device is not particularly limited in the method therefor as long as it is a method capable of coating the dispersion with desired thickness and uniformity, and the application may be performed, for example, an inkjet printing method, a spin coating method or a screen printing method. Among others, application using a printing method such as inkjet printing and screen printing may be useful for applying the dispersion to a specific region and shortening the production process.

The coating may be performed such that the thickness of the dopant injection layer obtained by drying the dispersion layer is 10 nm or more, 30 nm or more, 50 nm or more, 100 nm or more, or 200 nm or more, and 2,000 nm or less, 1,000 nm or less, 500 nm or less, or 300 nm or less. In the second aspect of the present invention, the thickness of the dopant injection layer can be determined by taking into account, for example, the degree of doping of the doped layer in the obtained semiconductor device, the thickness of the dope injection layer removable by a laser, or the thickness of the dope injection layer allowed to remain on the semiconductor substrate or layer. However, the thickness of the dopant injection layer is not particularly limited as long as the effects of the second aspect of the present invention are obtained.

<Dispersion Medium of Dispersion>

The dispersion medium of the dispersion is not limited as long as the object and effects of the second aspect of the present invention are not impaired, and, for example, an organic solvent incapable of reacting with the particles for use in the second aspect of the present invention can be used. Specifically, the dispersion medium may be a dispersion medium recited in the first aspect of the present invention, such as isopropyl alcohol (IPA).

(Particles of Dispersion)

The particles of the dispersion are not limited if it is particles composed of the same element as the semiconductor layer or substrate and is doped with a p-type or n-type dopant, as long as the object and effects of the second aspect of the present invention are not impaired. Such particles include, for example, a silicon or germanium particles disclosed in Patent Documents 4 and 5. Specifically, the silicon or germanium particles includes silicon or germanium particles obtained by a laser pyrolysis process, particularly, a laser pyrolysis process using a $CO_2$ laser.

In the particles of the dispersion, for injecting a dopant from the particles upon light irradiation, it may be preferred that the crystallization degree of particles is relatively low and/or the particle diameter of particles is relatively small.

In addition, for example, the average primary particle diameter of the particles may be 1 nm or more, 3 nm or more, 5 nm or more, 10 nm or more, or 15 nm or more. Also, the average primary particle diameter of the particles may be 100 nm or less, 50 nm or less, 40 nm or less, 30 nm or less, 20 nm or less, or 10 nm or less.

Here, in the second aspect of the present invention, the average primary particle diameter of the particles can be determined as described in the first aspect of the present invention. Incidentally, in Examples, the average primary particle diameter of the silicon particles was determined by performing TEM observation and analyzing the image at a magnification of 100,000. Based on an aggregate of n number of 500 or more, the average primary particle diameter and dispersion of the silicon particle dispersion were calculated.

The dopant for doing the particles of the dispersion may be either a p-type or n-type dopant and is selected, for example, from dopants recited in the first aspect of the present invention.

The degree of doping of the particles of the dispersion can be determined depending on the desired dopant concentration or the like in the dopant injection layer and the semiconductor layer or substrate. Specifically, the dopant concentration may be, for example, the dopant concentration given in the first aspect of the present invention. Also, the dopant concentration may be, for example, $1\times10^{22}$ atoms/cm$^3$ or less, or $1\times10^{21}$ atoms/cm$^3$ or less.

(Drying of Dispersion)

Drying in the method of the second aspect of the present invention for manufacturing a semiconductor device is not particularly limited as long as it is a method capable of substantially removing the dispersion medium from the dispersion, and drying can be performed, for example, by placing the substrate with the dispersion on a hot plate or in a heating atmosphere.

The drying temperature can be selected, for example, so as not to cause deterioration or the like of the substrate or the particles of the dispersion and may be selected to be, for example, 50°C or more, 70°C or more, 90°C or more, and 100°C or less, 200°C or less, 300°C or less, 400°C or less, 500°C or less, 600°C or less, 700°C or less, or 800°C or less.

(Light Irradiation)

Light irradiation in the method of the second aspect of the present invention for manufacturing a semiconductor device may be any light irradiation capable of diffusing the p-type or n-type dopant contained in the dopant injection layer into the selected region of the semiconductor layer or substrate and at the same time, at least partially removing the region corresponding to the first dopant injection layer out of the first dopant injection layer and the first and/or second passivation layers. Incidentally, as regards the second aspect of the present invention, the expression "at least partially removing" means that at least a part of the dopant injection layer and the first and/or second passivation layers is removed, and encompasses not only a case where such a layer is removed by the removal to an extent enabling formation of an electrode directly on the doped layer but also a case where the remaining layer such as dopant injection layer needs to be further removed by another treatment such as etching and cleaning.

In the case of employing such light irradiation, the dopant injection layer, passivation layer and surface portion of the below-located semiconductor layer or substrate are rapidly cooled due to transfer of heat to the main body portion of the semiconductor layer or substrate. Therefore, in the method of the second aspect of the present invention, the first region can be doped with the p-type or n-type dopant to form a doped layer without exposing the main body portion of the semiconductor layer or substrate to high heat.

<Irradiated Light>

As the irradiated light, any light can be employed if doping or the like of a specific region of the semiconductor layer or substrate can be achieved as above. As described in the first aspect of the present invention, for example, laser light composed of a single wavelength can be used as the irradiated light. Incidentally, it is effective to perform the irradiation by using light at a wavelength which is absorbed by Si.

In the case of performing the light irradiation by using pulsed light, as for the number of irradiations, irradiation energy, irradiation time and the like, descriptions in the later-described third aspect of the present invention can be referred to.

Here, if the irradiation energy of light is too small, desired dopant injection and removal of the dopant injection layer and passivation layer may not be achieved. Also, if the irradiation energy of light is too large, the irradiation may cause damage to the semiconductor layer or substrate. Incidentally, the optimal conditions such as irradiation energy and number of irradiations are dependent on, for example, the wavelength of light irradiation used or the properties of particle, and one skilled in the art can determine the optimal value by performing an experiment with reference to the description of the present invention.

<Irradiation Atmosphere>

The light irradiation for sintering the dispersion particles is preferably performed in a non-oxidizing atmosphere, for example, an atmosphere composed of hydrogen, a rare gas, nitrogen or a combination thereof, so as to reduce the effect on the properties of the semiconductor device. As for the specific irradiation atmosphere, description in the first aspect of the present invention can be referred to. Incidentally, hydrogen has an action of reducing the dispersion particles and for forming a continuous layer by reducing the oxidized surface portion, it may be preferred that the atmosphere contains hydrogen.

<<Semiconductor Device>>

In the semiconductor device of the second aspect of the present invention, a passivation layer is stacked on the semiconductor substrate or layer; in a first region of the semiconductor substrate or layer, the passivation layer is at least partially removed, first particles is sintered to the semiconductor substrate or layer, and a first electrode reaching the first region through the passivation layer is formed via the first particle; the first particles is substantially formed of the same element as the semiconductor layer or substrate and is doped with a p-type or n-type dopant; and the concentration of the dopant is $1 \times 10^{17}$ atoms/cm$^3$ or more at a depth of 0.1 $\mu$m from the surface of the first region.

In one embodiment of the semiconductor device of the second aspect of the present invention, in a second region of the semiconductor substrate or layer, the passivation layer is at least partially removed, second particles is sintered to the semiconductor substrate or layer, and a second electrode reaching the second region through the passivation layer is formed via the second particle; the second particles is substantially formed of the same element as the semiconductor layer or substrate and is doped with a dopant of a type different from the dopant of the first particle; and the concentration of the dopant is $1 \times 10^{17}$ atoms/cm$^3$ or more at a depth of 0.1 $\mu$m from the surface of the second region.

This semiconductor device is, for example, a solar cell or a thin-layer transistor.

The semiconductor device of the second aspect of the present invention is not particularly limited in its manufacturing method but can be obtained, for example, by the method of the second aspect of the present invention. For details of each constituent element of the semiconductor device of the second aspect of the present invention, descriptions regarding the method of the second aspect of the present invention for manufacturing a semiconductor device can be referred to.

<< <<Third Aspect of the Present Invention>> >>

<<Dopant Composition>>

The dopant composition of the third aspect of the present invention contains a solvent, a dopant compound having a dopant element, and light-absorbing particles composed of a material having at least one peak absorption wavelength in the range of 100 to 1,000 nm.

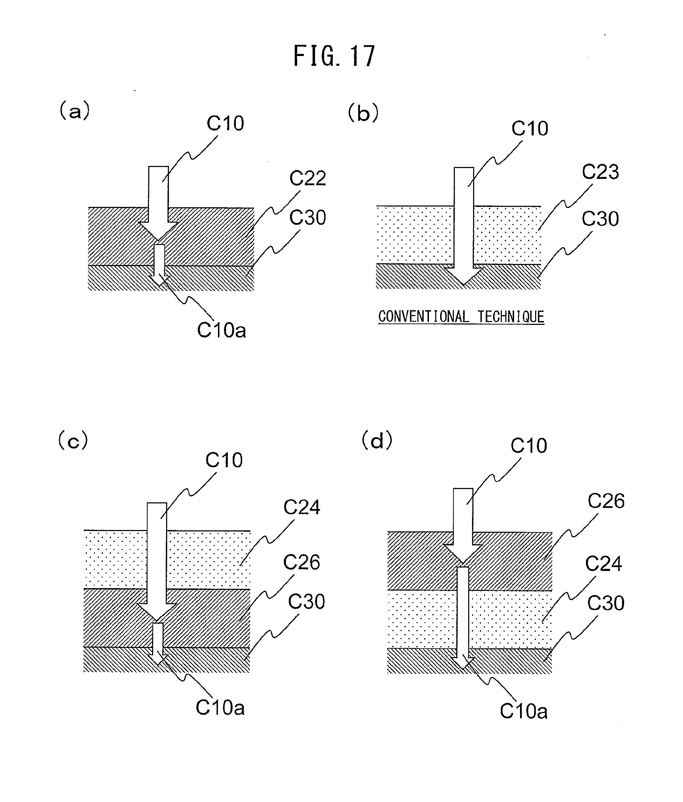

In the case of forming a dopant injection layer (C22) on a semiconductor substrate (C30) by using the dopant composition of the third aspect of the present invention, as shown in Fig. 17(a), upon irradiation with light (C10) such as green laser (wavelength: 532 nm), the light-absorbing particles in the dopant injection layer (C22) absorbs at least a part of the irradiated light (C10) to heat the layer, and the below-located semiconductor substrate (C30) optionally absorbs the remainder (C10a) of light to heat the substrate, whereby diffusion of the dopant from the dopant injection layer (C22) into the semiconductor substrate (C30) is promoted.

On the other hand, the conventional dopant composition does not contain light-absorbing particles and in turn, the obtained dopant injection layer (C23) does not contain a light-absorbing particle. Therefore, in the conventional technique, as shown in Fig. 17(b), upon irradiation with light (C10), light passes through the conventional dopant injection layer (C23) but only the below-located semiconductor substrate (C30) absorbs light to heat the substrate, and the heat of the semiconductor substrate (C30) transfers to the conventional dopant injection layer (C23) to heat the dopant injection layer (C23), whereby diffusion of the dopant from the dopant injection layer (C23) into the semiconductor substrate (C30) is promoted.

In this way, when the dopant injection layer does not contain a light-absorbing particle, light passes through the dopant injection layer and is absorbed only by the below-located semiconductor substrate, and there is the possibility of, for example, producing a defect in the semiconductor substrate by light irradiation or deteriorating the semiconductor substrate due to heat. On the other hand, in the case of using the dopant composition of the third aspect of the present invention, at least a part of the irradiated light is absorbed by the dopant injection layer, whereby occurrence of the above-described problem can be suppressed.

<Solvent>

The solvent is not limited as long as the object and effects of the third aspect of the present invention are not impaired, and, for example, an organic solvent incapable of reacting with the particles for use in the dopant composition can be used. Specifically, the solvent may be a solvent such as isopropyl alcohol (IPA) recited as the dispersion medium in the present invention.

<Light-Absorbing Particle>

The material constituting the light-absorbing particles for use in the dopant composition of the third aspect of the present invention has at least one peak absorption wavelength in the range of 100 to 1,000 nm, for example, from 200 to 1,000 nm, from 200 to 800 nm, or from 200 to 600 nm. Here, the peak at the peak absorption wavelength may be a maximum peak in the range of 100 to 2,500 nm or from 200 to 2,500 nm.

The light-absorbing particles are composed of, for example, a metal or half metal element, particularly, silicon, germanium or a combination thereof. The metal or half metal element generally has an absorption peak in the visible region, and therefore can be used as the light-absorbing particles in the dopant composition of the third aspect of the present invention. In this regard, for example, the silicon has an absorption peak in the range of 200 to 400 nm.

Incidentally, a metal oxide such as silicon oxide does not have an absorption peak in the visible region, and therefore cannot be used as the light-absorbing particle. However, even metal oxide particles can be used as the light-absorbing particles of the third aspect of the present invention if it has at least one peak absorption wavelength in the range of 100 to 1,000 nm.

Such a light-absorbing particle, particularly, silicon particles or a germanium particle, can be obtained, for example, by a laser pyrolysis process, particularly, a laser pyrolysis process using a $CO_2$ laser.

Also, the light-absorbing particles are composed of, for example, the same element as the semiconductor substrate that is doped using the dopant composition of the third aspect of the present invention. Accordingly, for example, when the semiconductor substrate is composed of silicon, germanium or a combination thereof, the light-absorbing particles may be composed of silicon, germanium or a combination thereof. Constituting the light-absorbing particles by the same element as the semiconductor substrate may be preferred for preventing contamination of the semiconductor substrate with the light-absorbing particle.

The light-absorbing particles may contain substantially no dopant or may be doped with a dopant. Here, as regards the third aspect of the present invention, the expression "contain substantially no dopant" means that a doping element is not intentionally added, and in other words, means that the particles may contain a very slight amount of an unintentionally mixed dopant.

In the case where the light-absorbing particles are doped with a dopant, the particles may be doped with either a p-type or n-type dopant. This dopant is selected, for example, from dopants recited in the first aspect of the present invention.

Also, the degree of doping of the light-absorbing particles can be determined depending on, for example, the concentration of the dopant compound contained in the dopant composition or the desired dopant concentration in the semiconductor substrate. Specifically, the dopant concentration of the light-absorbing particles may be, for example, the dopant concentration given in the first aspect of the present invention.

The light-absorbing particles may have an average primary particle diameter of, for example, 1 nm or more, 3 nm or more, 5 nm or more, 10 nm or more, or 15 nm or more. Also, the light-absorbing particles may have an average primary particle diameter of, for example, 100 nm or less, 50 nm or less, 40 nm or less, 30 nm or less, 20 nm or less, or 10 nm or less. A relatively small particle diameter of the light-absorbing particles may be preferred, because the dopant injection layer containing the light-absorbing particles is uniformly heated by light irradiation.

The content of the light-absorbing particles in the dopant composition of the third aspect of the present invention may be determined by taking into account, for example, the light absorptivity of the light-absorbing particles for the wavelength of light used or the handleability of the dopant composition. The dopant composition of the third aspect of the present invention may contain the light-absorbing particles in an amount of, for example, 0.1 mass% or more, 0.5 mass% or more, 1.0 mass% or more, 2 mass% or more, or 3 mass% or more.

<Dopant Compound>

The dopant compound for use in the dopant composition of the third aspect of the present invention has a dopant element.

The dopant element may be either p-type or n-type. This dopant element may be the dopant element recited above with respect to the light-absorbing particle, for example, boron (B) or phosphorus (P).

The dopant compound may be specifically any compound capable of injecting a dopant element into the semiconductor substrate when heated in the dopant injection layer, and a compound employed in general for this purpose may be used.

The dopant compound having an n-type dopant includes, for example, $P_2O_5$, a phosphoric acid ester such as dibutyl phosphate, tributyl phosphate, monoethyl phosphate, diethyl phosphate, triethyl phosphate, monopropyl phosphate and dipropyl phosphate, $Bi_2O_3$, Sb $(OCH_2CH_3)_3$, $SbCl_3$, $H_3AsO_4$, and As$(OC_4H_9)_3$. The dopant compound having a p-type dopant includes, for example, $B_2O_3$, $Al_2O_3$, and gallium trichloride.

The concentration of the dopant compound in the dopant composition of the third aspect of the present invention and the ratio between the light-absorbing particles and the dopant compound can be determined by taking into account, for example, the desired doping depth or doping concentration of the doped layer.

<Others>

The dopant composition of the third aspect of the present invention may contain, as other components, any other components such as binder resin, surfactant and thickener. As the binder resin, for example, ethyl cellulose may be used in view of thixotropy, dispersibility of silicon particle, and the like.

«Dopant Injection Layer»

<First Dopant Injection Layer>

The first dopant injection layer of the third aspect of the present invention contains a dopant compound having a dopant element and a light-absorbing particles composed of a material having at least one peak absorption wavelength in the range of 100 to 1,000 nm.
According to such a dopant injection layer of the third aspect of the present invention, as explained above by referring to Fig. 17(a) with respect to the dopant composition of the third aspect of the present invention, diffusion of the dopant from the dopant injection layer (C22) into the semiconductor substrate (C30) can be promoted.

<Second Dopant Injection Layer>

The second dopant injection layer of the third aspect of the present invention has the following layers stacked one on another:

a dopant compound-containing layer containing a dopant compound having a dopant element, and
a light-absorbing particle-containing layer containing light-absorbing particles composed of a material having a peak absorption wavelength in the range of 100 to 1,000 nm.

In the second dopant injection layer of the third aspect of the present invention, the dopant compound-containing layer may be stacked on the light-absorbing particle-containing layer (Fig. 17(c)), or conversely, the light-absorbing particle-containing layer may be stacked on the dopant compound-containing layer (Fig. 17(d)).
In the second dopant injection layer of the third aspect of the present invention, the dopant compound-containing layer may further contain light-absorbing particles composed of a material having a peak absorption wavelength in the range of 100 to 1,000 nm, or the light-absorbing particle-containing layer may further contain a dopant compound having a dopant element. That is, in the second dopant injection layer of the third aspect of the present invention, either one or both of the dopant compound-containing layer and the light-absorbing particle-containing layer may be the dopant composition of the third aspect of the present invention.
According to such a second dopant composition of the third aspect of the present invention, as shown in Figs. 17(c) and (d), upon irradiation with light (C10) such as green laser (wavelength: 532 nm), the light-absorbing particles in the light-absorbing particle-containing layer (C26) absorbs at least a part of the irradiated light (C10) to heat the layer, and the below-located semiconductor substrate (C30) optionally absorbs the remainder (C10a) of light passed through the dopant compound-containing layer (C24) to heat the substrate, whereby diffusion of the dopant from the dopant injection layers (C24, C26) into the semiconductor substrate (C30) can be promoted.

<Semiconductor Substrate>

The dopant injection layer of the third aspect of the present invention may be stacked on a semiconductor substrate. In this case, the semiconductor substrate may be any semiconductor substrate intended to form a dopant injection layer thereon by injecting a dopant.
The semiconductor substrate may be composed of, for example, silicon, germanium or a combination thereof. Accordingly, the semiconductor substrate includes, for example, a silicon wafer, a germanium wafer, an amorphous silicon layer, an amorphous germanium layer, a crystalline silicon layer, and a crystalline germanium layer.

<Formation of Dopant Injection Layer>

The first dopant injection layer of the third aspect of the present invention may be formed by applying, in any manner, the dopant composition of the third aspect of the present invention to the semiconductor substrate and may be formed, for example, by an inkjet method, a spin coating method or a screen printing method. Among others, the dopant injection layer may be formed using a printing method such as inkjet printing and screen printing, and this processing may be particularly useful for shortening the production process. For example, the dopant injection layer having a pattern can be formed by applying the dopant composition by a printing method.

Also, the second dopant injection layer of the third aspect of the present invention may be formed by applying, in place of the dopant composition of the third aspect of the present invention, the dopant compound-containing composition containing a solvent and a dopant compound and the light-absorbing particle-containing composition containing a solvent and a light-absorbing particle, to the semiconductor substrate.

The thickness of the obtained dopant injection layer is preferably a thickness making it possible to successfully inject the dopant element from the dopant injection layer into the semiconductor substrate by light irradiation. Accordingly, the thickness may be, for example, 50 nm or more, 100 nm or more, or 200 nm or more, and 5,000 nm or less, 4,000 nm or less, or 3,000 nm or less.

The dopant injection layer may be optionally dried by a drying step. This drying may be performed in any manner capable of substantially removing the solvent from the dopant injection layer and can be performed, for example, by placing the substrate with the dopant injection layer on a hot plate or in a heating atmosphere.

The drying temperature in this drying can be selected, for example, so as not to cause deterioration or the like of the semiconductor substrate and the dopant injection layer and may be selected to be, for example, 50°C or more, 70°C or more, or 90°C or more, and be 100°C or less, 150°C or less, 200°C or less, or 250°C or less.

«Method for Forming Doped Layer»

The method of the third aspect of the present invention for forming a doped layer comprises irradiating the dopant injection layer of the third aspect of the present invention with light to diffuse the dopant element into the semiconductor substrate.

According to such a method of the third aspect of the present invention, as described by referring to Figs. 17(a), (c) and (d), diffusion of the dopant from the dopant injection layers (C22, C22, C24) into the semiconductor substrate (30) can be promoted.

In this method of the third aspect of the present invention, the light-absorbing particles preferably has, at the main wavelength of the irradiated light, a light absorptivity of 0.05 times or more, or 0.1 times or more, the light absorptivity at the peak absorption wavelength, because the irradiated light is efficiently absorbed and converted to heat.

<Light Irradiation>

Light irradiation may be any light irradiation capable of diffusing the dopant contained in the dopant injection layer into the selected region of the semiconductor substrate.

As the irradiated light, any light can be employed if the dopant can be diffused as above. As described in the first aspect of the present invention, for example, laser light composed of a single wavelength can be used as the irradiated light.

In the case of performing the irradiation with pulsed light having a relatively short wavelength (for example, a YVO4 laser having a wavelength of 355 nm), the number of pulsed light irradiations may be, for example, 1 or more, 2 or more, 5 or more, or 10 or more, and 100 or less, 80 or less, or 50 or less. In this case, the irradiation energy of pulsed light may be, for example, 15 mJ/(cm$^2$·shot) or more, 50 mJ/(cm$^2$·shot) or more, 100 mJ/(cm$^2$·shot) or more, 150 mJ/(cm$^2$·shot) or more, 200 mJ/(cm$^2$·shot) or more, or 300 mJ/(cm$^2$·shot) or more, and 1,000 mJ/(cm$^2$·shot) or less, or 800 mJ/(cm$^2$·shot) or less. Furthermore, in this case, the irradiation time of pulsed light may be, for example, 200 nanoseconds/shot or less, 100 nanoseconds/shot or less, or 50 nanoseconds/shot or less.

In the case of performing the irradiation with pulsed light having a relatively long wavelength (for example, a green laser having a wavelength of 532 nm), the number of pulsed light irradiations may be, for example, 1 or more, 5 or more, 10 or more, 25 or more, or 50 or more, and 300 or less, 200 or less, or 100 or less. In this case, the irradiation energy of pulsed light may be, for example, 100 mJ/(cm$^2$·shot) or more, 300 mJ/(cm$^2$·shot) or more, 500 mJ/(cm$^2$·shot) or more, 900 mJ/(cm$^2$·shot) or more, 1,000 mJ/(cm$^2$·shot) or more, or 1, 300 mJ/(cm$^2$·shot) or more, and 5,000 mJ/(cm$^2$·shot) or less, or 4,000 mJ/(cm$^2$·shot) or less. Furthermore, in this case, the irradiation time of pulsed light may be, for example, 50 nanoseconds/shot or more, 100 nanoseconds/shot or more, or 150 nanoseconds/shot or more, and 300 nanoseconds/shot or less, 200 nanoseconds/shot or less, or 180 nanoseconds/shot or less.

If the number of light irradiations is too small, the energy per pulse required to achieve the desired dopant diffusion becomes large, leaving the possibility of damage to the dopant injection layer or deterioration of the properties of the semiconductor substrate below the dopant injection layer. Also, if the irradiation energy per pulse is too small, sufficient dopant diffusion into the semiconductor substrate may not occur. Also, even when dopant diffusion into the semiconductor substrate occurs, if the energy is too small, the number of irradiations necessary for obtaining the required cumulative energy is increased, and therefore the processing time may be prolonged.

The optimal conditions such as irradiation energy and number of irradiations are dependent on, for example, the wavelength of light irradiation used or the properties of light-absorbing particle, and one skilled in the art can determine the optimal value by performing an experiment with reference to the description of the present invention.

Incidentally, selecting the number of irradiations, irradiation energy and irradiation time of pulsed light in the ranges above may be preferred for achieving dopant diffusion into the semiconductor substrate without causing deterioration of the below-located semiconductor substrate.

(Irradiation Atmosphere)

Light irradiation may be performed under the atmosphere but is preferably performed in a non-oxidizing atmosphere according to the material, for example, in an atmosphere composed of hydrogen, a rare gas, nitrogen or a combination thereof, so as to prevent oxidation of the light-absorbing particle. The rare gas includes, particularly argon, helium and neon. In order to create a non-oxidizing atmosphere, the oxygen content in the atmosphere may be 1 vol% or less, 0.5 vol% or less, 0.1 vol% or less, or 0.01 vol% or less.

«Semiconductor Device and Manufacturing Method Thereof»

The method of the third aspect of the present invention for manufacturing a semiconductor device comprises forming a doped layer by the method of the third aspect of the present invention. The semiconductor device manufactured by the method of the third aspect of the present invention includes a solar cell. Also, the semiconductor device of the third aspect of the present invention is manufactured by the method of the third aspect of the present invention for manufacturing a semiconductor device.

<<Others>>

The third aspect of the present invention is not limited to the above-described embodiments, but modification such as various design changes based on the knowledge of one skilled in the art may be made therein, and embodiments to which such modification is added are also included in the scope of the third aspect of the present invention. New embodiments resulting from combination of the above-described embodiment and the following modification example have respective effects of the combined embodiment and modification example.

[Examples]

<<First Aspect of the Present Invention>>

<Example A1-1>

In Example A1, a laminate having the configuration shown in Fig. 1(d1) was obtained. That is, in Example A1, a laminate where a sintered silicon particle layer and a light-transmitting layer are stacked on a substrate was obtained.

(Preparation of Silicon particle dispersion)

The silicon particles were produced from $SiH_4$ gas as the raw material by a Laser Pyrolysis (LP) process using a $CO_2$ laser. The obtained silicon particles had an average primary particle diameter of about 7 nm. These silicon particles were ultrasonically dispersed in isopropyl alcohol (IPA) to obtain a silicon particle dispersion having a solid content concentration of 3 mass%.

Incidentally, the average primary particle diameter of the silicon particles was calculated based on an aggregate of 500 or more particles by performing TEM observation and analyzing the image at a magnification of 100,000.

(Preparation of Substrate)

A glass substrate was ultrasonically cleaned for 5 minutes in each of acetone and isopropyl alcohol.

(Coating of Silicon particle dispersion)

A few drops of the silicon particle dispersion were dropped on the substrate and spin-coated at 500 rpm over 5 seconds and further at 4,000 rpm over 10 seconds, thereby coating the silicon particle dispersion on the substrate.

(Drying of Silicon particle dispersion)

The substrate coated with the silicon particle dispersion was dried on a hot plate at 70°C to remove the isopropyl alcohol as the dispersion medium in the silicon particle dispersion, and thereby obtain a green silicon particle layer (film thickness: 300 nm) containing silicon particles (average primary particle diameter: about 7 nm).

(Formation of Light-Transmitting Layer)

A film of MSQ (methyl silsesquioxane) as a compound having light transmittability was formed on the substrate coated with the green silicon particle layer. Specifically, a few drops of a solution obtained by dissolving MSQ in propylene glycol monomethyl ether acetate (PGMEA) (solid content concentration: 30 mass%, produced by Honeywell, trade name: PTS R-6) were dropped on the substrate coated with the green silicon particle layer, then spin-coated at 500 rpm over 5 seconds and further at 3,200 rpm over 20 seconds, and dried under heating on a hot plate at 80°C over 5 minutes in an $N_2$ atmosphere and further at 400°C over 60 minutes in a furnace, whereby the MSQ film was obtained. The film thickness of the obtained MSQ film was 700 nm. The obtained laminate had the configuration shown in Fig. 1(c).

(Light Irradiation)

The laminate in which the light-transmitting layer was stacked on the green silicon particle layer was irradiated with a $YVO_4$ laser (wavelength: 355 nm) by using a laser light irradiation apparatus (trade name: Osprey 355-2-0, manufactured by Quantronix) to sinter the silicon particles in the green silicon particle layer, and thereby produce a sintered silicon particle layer. The laser irradiation conditions were an irradiation energy of 50 mJ/(cm$^2$·shot) and a number of shots of 20, and laser irradiation was performed in an atmosphere of nitrogen ($N_2$) containing 3.5% hydrogen ($H_2$).

(Evaluation)

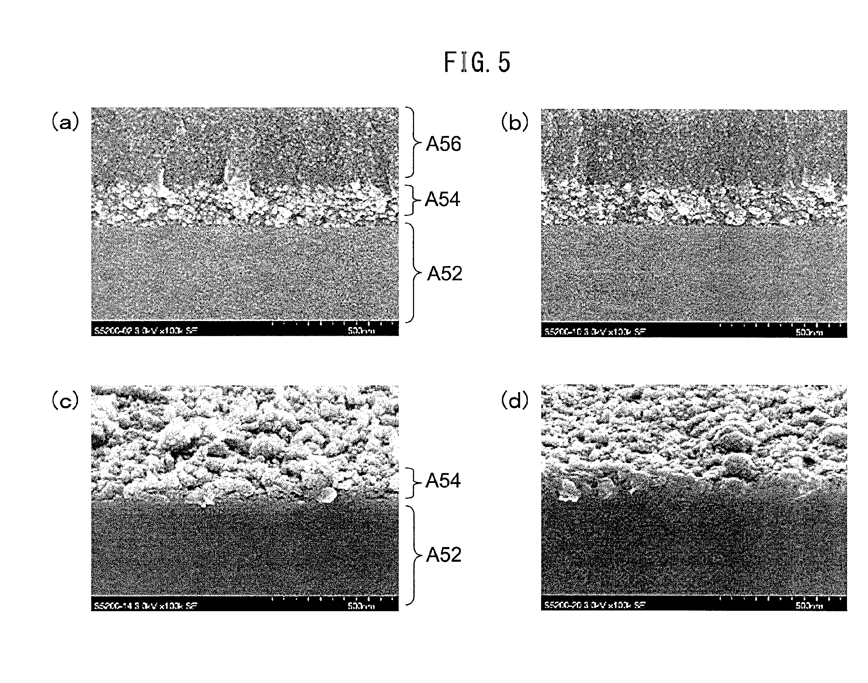

The cross-sectional observation and evaluation of the produced laminate was performed at a sample tilt angle of 20° and a magnification of 100,000 by means of FE-SEM (field emission scanning electron microscopy) (Model S5200, manufactured by Hitachi High-Technologies Corp.). Fig. 5(a) shows the observation results of FE-SEM. As shown in Fig. 5(a), the laminate had a configuration where a sintered silicon particle layer (A54) and a light-transmitting layer (A56) are staked on a substrate (A52). That is, the laminate obtained in Example A1-1 had the configuration shown in Fig. 1(d1).

In addition, the crystallization degree was determined by performing Raman spectroscopic analysis of the sintered silicon particle layer. The crystallization degree by Raman spectroscopic analysis is shown in Table 1.

<Examples A1-2 to A1-4>

Sintered silicon particle layers were produced in the same manner as in Example A1-1 except that the laser irradiation energy was changed to 100 mJ/(cm$^2$·shot), 200 mJ/(cm$^2$·shot) and 300 mJ/(cm$^2$·shot) in Examples A1-2 to A1-4, respectively.

The laminate obtained in Example A1-2 had the configuration shown in Fig. 1(d1), that is, a configuration where a sintered silicon particle layer (A5) and a light-transmitting layer (A3) are stacked on a substrate (A10). Also, the laminates obtained in Examples A1-3 and 1-4 had the configuration shown in Fig. 1(d2), that is, a configuration where only a sintered silicon particle layer (A5) is stacked on a substrate (A10).

The laminates obtained in Examples A1-2 to A1-4 were evaluated by cross-sectional observation of the silicon layer, similarly to Example A1-1. Fig. 5(b) to Fig. 5(d) respectively show FE-SEM photographs of the laminates obtained in Examples A1-2 to A1-4. Also, the crystallization degrees of the sintered silicon particle layers by Raman spectroscopic analysis are shown in Table 1.

<Examples A2-1 to A2-4>

Sintered silicon particle layers were produced in the same manner as in Example A1-1 except that in Examples A2-1 to A2-4, a light-transmitting layer (see below) containing, as the main component, silicon oxide obtained from a silanol solution was used as the light-transmitting layer. Incidentally, the laser irradiation energy was changed to 100 mJ/(cm$^2$·shot), 200 mJ/(cm$^2$·shot), 300 mJ/(cm$^2$·shot) and 400 mJ/(cm$^2$·shot) in Examples A2-1 to A2-4, respectively.

The laminates obtained in Examples A2-1 and A2-2 had the configuration shown in Fig. 1(d1), that is, a configuration where a sintered silicon particle layer (A5) and a light-transmitting layer (A3) are stacked on a substrate (A10).

Also, the laminates obtained in Examples A2-3 and A2-4 had the configuration shown in Fig. 1(d2), that is, a configuration where only a sintered silicon particle layer (A5) is stacked on a substrate (A10).

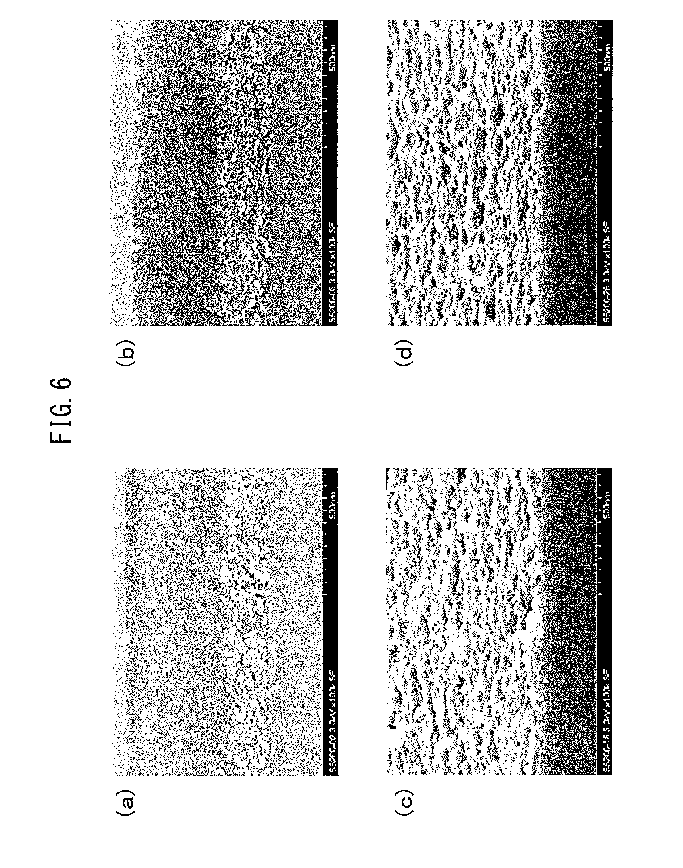

The laminates obtained in Examples A2-1 to A2-4 were evaluated by cross-sectional observation of the silicon layer, similarly to Example A1-1. Fig. 6(a) to Fig. 6(d) respectively show FE-SEM photographs of the laminates obtained in Examples A2-1 to A2-4. Also, the crystallization degrees by Raman spectroscopic analysis are shown in Table 1.

(Formation of Light-Transmitting Layer)

The light-transmitting layer containing, as the main component, silicon oxide used in Examples A2-1 to A2-4 was formed on the substrate coated with the green silicon particle layer by using a silanol solution (OCD Type-7 12000-T (produced by Tokyo Ohka Kogyo Co., Ltd.). Incidentally, the coating-type insulating film used as the light-transmitting layer had an ultraviolet-visible transmittance of 99% or more.

Specifically, a few drops of the solution above were dropped on the substrate coated with the green silicon particle layer, spin-coated at 5,000 rpm for 15 seconds, and heated/dried at 80°C over 1 minute, then at 150°C over 2 minutes on a hot plate under the atmosphere and further at 400°C over 30 minutes in a tubular furnace in a nitrogen ($N_2$) atmosphere, whereby the coating-type insulating film was obtained. The film thickness of the obtained film was 400 nm.

(Comparative Examples A1 to A4)

In Comparative Examples A1 to A4, sintered silicon particle layers were produced in the same manner as in Example A1-1 except for not using the light-transmitting layer. Incidentally, in Comparative Examples A1 to A4, the laser irradiation energy was changed to 100 mJ/($cm^2$·shot), 200 mJ/($cm^2$·shot), 300 mJ/($cm^2$·shot) and 400 mJ/($cm^2$·shot), respectively.

The laminates obtained in Comparative Examples A1 to A4 had the configuration shown in Fig. 1(d2), that is, a configuration where only a sintered silicon particle layer (A5) is stacked on a substrate (A10).

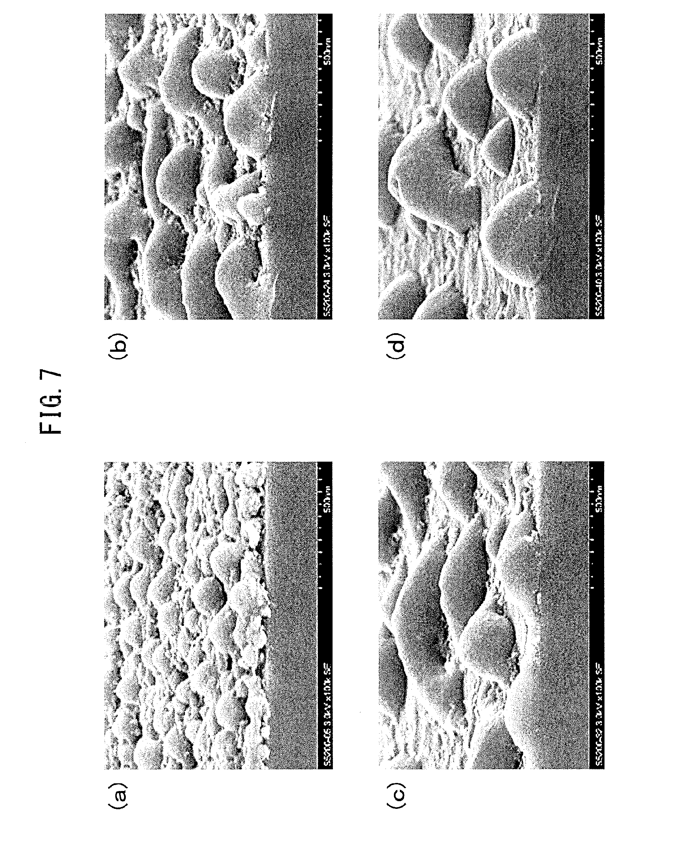

The laminates obtained in Comparative Examples A1 to 4 were evaluated by cross-sectional observation of the silicon layer, similarly to Example A1-1. Fig. 7(a) to Fig. 7(d) respectively show FE-SEM photographs of the laminates obtained in Comparative Examples A1 to 4.

<Examples A3-1 to A3-5>

Sintered silicon particle layers were produced in the same manner as in Examples A2-1 to A2-4 except that silicon particles having an average primary particle diameter of about 20 nm was used, the film thickness of the light-transmitting layer was changed, and green laser (wavelength: 532 nm) from a laser light irradiation apparatus (trade name: Osprey 532-8-0, manufactured by Quantronix) was used for the light irradiation in Examples A3-1 to A3-5. Incidentally, the laser irradiation energy was changed, as shown in Table 2 below, to be from 1,000 mJ/($cm^2$·shot) to 1,800 mJ/($cm^2$·shot) in Examples A3-1 to A3-3.

Here, the light-transmitting layers of Examples A3-1 to A3-5 were produced in the same manner as in Examples A2-1 to A2-4 except that the spin coating conditions of the silanol solution dropped on the green silicon particle layer were 4,000 rpm and 20 seconds and the film thickness of the obtained film was 300 nm.

The laminates obtained in Examples A3-1 to 3-3 had the configuration shown in Fig. 1(d1), that is, a configuration where a sintered silicon particle layer (A5) and a light-transmitting layer (A3) are stacked on a substrate (A10). Also, the laminates obtained in Examples A3-4 and A3-5 had the configuration shown in Fig. 1(d2), that is, a configuration where only a sintered silicon particle layer (A5) is stacked on a substrate (A10).

<Examples A4-1 to A4-5>

Sintered silicon particle layers were produced in the same manner as in Examples A3-1 to 3-5 except that the film thickness of the light-transmitting layer was changed in Examples A4-1 to A4-5.

Here, the light-transmitting layers of Examples A4-1 to A4-5 were produced in the same manner as in Examples A3-1 to A3-5 except that the spin coating conditions of the silanol solution dropped on the green silicon particle layer were 2,000 rpm and 20 seconds and the film thickness of the obtained film was 400 nm.

The laminates obtained in Examples A4-1 to A4-3 had the configuration shown in Fig. 1(d1), that is, a configuration where a sintered silicon particle layer (A5) and a light-transmitting layer (A3) are stacked on a substrate (A10). Also, the laminates obtained in Examples A4-4 and A4-5 had the configuration shown in Fig. 1(d2), that is, a configuration where only a sintered silicon particle layer (A5) is stacked on a substrate (A10).

<Examples A5-1 to A5-5>

Sintered silicon particle layers were produced in the same manner as in Examples A3-1 to A3-5 except that the film thickness of the light-transmitting layer was changed in Examples A5-1 to A5-5.

Here, the light-transmitting layers of Examples A5-1 to A5-5 were produced in the same manner as in Examples A3-1 to A3-5 except that the spin coating conditions of the silanol solution dropped on the green silicon particle layer were 1,000 rpm and 20 seconds and the film thickness of the obtained film was 650 nm.

The laminates obtained in Examples A5-1 to A5-4 had the configuration shown in Fig. 1(d1), that is, a configuration where a sintered silicon particle layer (A5) and a light-transmitting layer (A3) are stacked on a substrate (A10). Also, the laminate obtained in Example A5-5 had the configuration shown in Fig. 1(d2), that is, a configuration where only a sintered silicon particle layer (A5) is stacked on a substrate (A10).

(Evaluation Results)

The evaluation results of Examples A1-1 to A2-4 and Comparative Examples A1 to 4 are shown together with the production conditions in Table 1 below, and the evaluation results of Examples A3-1 to A5-5 are shown together with the production conditions in Table 2 below. Incidentally, the roughness of the laminate is the arithmetic mean roughness (Ra) determined by a contact stylus profilometer (DEKTAK manufactured by ULVAC, Inc.) in accordance with JIS B 0601 (1994) and was determined with a reference length of 1,000 $\mu$m. The measurement of roughness was performed on the unevenness in the center part of the portion irradiated with laser.

[Table 1]

Table 1

| | Light-Transmitting Layer | | Laser | | Crystallization Degree*1 | Laminate | | |
|---|---|---|---|---|---|---|---|---|
| | kind | Film Thickness (nm) | Output (mJ/cm$^2$) | Number of Shots (times) | | FE-SEM | Layer Configuration | Roughness (nm) |
| Example A1-1 | MSQ | 700 | 50 | 20 | 77% | Fig. 5(a) | Fig. 1(d1) | - |
| Example A1-2 | | | 100 | | 74% | Fig. 5(b) | Fig. 1(d1) | - |
| Example A1-3 | | | 200 | | - | Fig. 5(c) | Fig. 1(d2) | - |
| Example A1-4 | | | 300 | | 93% | Fig. 5(d) | Fig. 1(d2) | - |
| Example A2-1 | OCD Type-7 12000-T | 400 | 100 | 20 | 69% | Fig. 6(a) | Fig. 1(d1) | - |
| Example A2-2 | | | 200 | | 79% | Fig. 6(b) | Fig. 1(d1) | - |
| Example A2-3 | | | 300 | | 93% | Fig. 6(c) | Fig. 1(d2) | - |
| Example A2-4 | | | 400 | | - | Fig. 6(d) | Fig. 1(d2) | - |
| Comparative Example A1 | None | - | 100 | 20 | - | Fig. 7(a) | Fig. 4(b) | - |
| Comparative Example A2 | | | 200 | | - | Fig. 7(b) | Fig. 4(b) | - |
| Comparative Example A3 | | | 300 | | - | Fig. 7(c) | Fig. 4(b) | - |
| Comparative Example A4 | | | 400 | | - | Fig. 7(d) | Fig. 4(b) | - |

[Table 2]

Table 2

| | Light-Transmitting Layer | | Laser | | Crystallization Degree*1 | Laminate | | |
|---|---|---|---|---|---|---|---|---|
| | kind | Film Thickness (nm) | Output (mJ/cm$^2$) | Number of Shots (times) | | FE-SEM | Layer Configuration | Roughness (nm) *2 |
| Example A3-1 | OCD Type-7 12000-T | 300 | 1000 | 1 | - | - | Fig. 1(d1) | 45.9 |
| Example A3-2 | | | 1200 | | - | - | Fig. 1(d1) | 47.8 |
| Example A3-3 | | | 1400 | | - | - | Fig. 1(d1) | 47.1 |
| Example A3-4 | | | 1600 | | - | - | Fig. 1(d2) | 38.9 |
| Example A3-5 | | | 1800 | | - | - | Fig. 1(d2) | 37.2 |
| Example A4-1 | OCD Type-7 12000-T | 400 | 1000 | 1 | - | - | Fig. 1(d1) | 30.2 |
| Example A4-2 | | | 1200 | | - | - | Fig. 1(d1) | 24.1 |
| Example A4-3 | | | 1400 | | - | - | Fig. 1(d1) | 57.4 |
| Example A4-4 | | | 1600 | | - | - | Fig. 1(d2) | 35.5 |
| Example A4-5 | | | 1800 | | - | - | Fig. 1(d2) | 45.1 |

(continued)

| | Light-Transmitting Layer | | Laser | | Crystallization Degree*1 | Laminate | | |
|---|---|---|---|---|---|---|---|---|
| | kind | Film Thickness (nm) | Output (mJ/cm$^2$) | Number of Shots (times) | | FE-SEM | Layer Configuration | Roughness (nm) *2 |
| Example A5-1 | OCD Type-7 12000-T | 650 | 1000 | 1 | - | - | Fig. 1(d1) | 57.0 |
| Example A5-2 | | | 1200 | | - | - | Fig. 1(d1) | 41.0 |
| Example A5-3 | | | 1400 | | - | - | Fig. 1(d1) | 37.8 |
| Example A5-4 | | | 1600 | | - | - | Fig. 1(d1) | 57.1 |
| Example A5-5 | | | 1800 | | - | - | Fig. 1(d2) | 28.5 |

When the sintered silicon particle layer of Example shown in Figs. 5(c) and (d) for Examples A1-3 and A1-4 and Figs. 6(c) and (d) for Examples A2-3 and A2-4 with the sintered silicon particle layer of Comparative Example shown in Figs. 7(a) to (d) for Comparative Examples A1 to A4, it is understood that the flatness and continuity of the surface are significantly improved in the sintered silicon particle layer of Example. Also, it is seen from Examples A1-4 and A2-3 of Table 1 that the crystallization degree of the sintered silicon particle layer of Example is significantly improved.

«Second Aspect of the Present Invention»

<Example B1>

(Preparation of Phosphorus (P)-Doped Silicon Particle)

The silicon particles were produced from a monosilane ($SiH_4$) gas as the raw material by a Laser Pyrolysis (LP) process using a carbon dioxide ($CO_2$) laser. At this time, a phosphine ($PH_3$) gas was introduced together with the $SiH_4$ gas to obtain a phosphorus-doped silicon particle.
The doping concentration of the obtained phosphorus-doped silicon particles was $1 \times 10^{21}$ atoms/cm$^3$. Also, the obtained phosphorus-doped silicon particles had an average primary particle diameter of 20.5 nm. Incidentally, the average primary particle diameter of the silicon particles was calculated based on an aggregate of 500 or more particles by performing TEM observation and analyzing the image at a magnification of 100,000.

(Preparation of Dispersion)

The phosphorus-doped silicon particles obtained as above were ultrasonically dispersed in isopropyl alcohol (IPA) to obtain a silicon particle dispersion having a solid content concentration of 2 mass%.

(Preparation of Substrate)

A silicon substrate was ultrasonically cleaned for 5 minutes in each of acetone and isopropyl alcohol, subjected to removal of the oxidized layer in a 5% ammonium fluoride solution over 10 minutes, and washed with pure water.

(Coating)

The silicon particle dispersion was coated on the silicon substrate in a line width of 200 $\mu$m by an inkjet printer (Dimatix).

(Drying)

The substrate coated with the silicon particle dispersion was dried on a hot plate at 80°C to remove isopropyl alcohol as the dispersion medium in the silicon particle dispersion, and thereby form a dopant injection layer (thickness: 200 nm) containing silicon particles.

(Formation of Passivation Layer)

On the substrate having formed thereon the dopant injection layer, a silicon nitride (SiN) layer having a thickness of 50 nm was formed as a passivation layer (second passivation layer) by plasma enhanced chemical vapor deposition (PE-CVD).

(Light Irradiation)

The laminate having the passivation layer on the dopant injection layer was irradiated with green laser (wavelength: 532 nm) by using a laser light irradiation apparatus (trade name: Osprey 532-8-0-2, manufactured by Quantronix) to dope the dopant into the base material and ablate the passivation layer and dopant injection layer.
Here, the laser irradiation conditions were an irradiation energy of 700 mJ/(cm$^2$·shot) and a number of shots of 20, and laser irradiation was performed in a nitrogen ($N_2$) atmosphere.

(Evaluation - Dynamic SIMS Measurement)

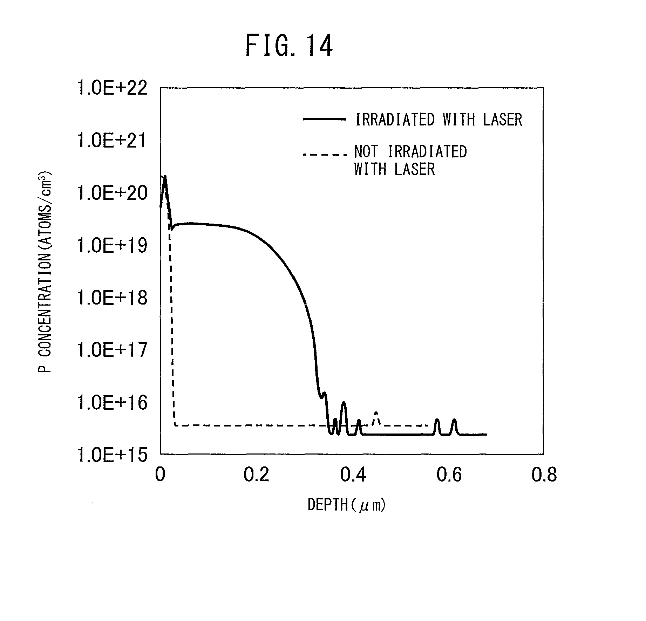

Dynamic SIMS (dynamic secondary ion mass spectrometry) of the produced substrate was performed using CAMECA IMS-7f. The measurement conditions were a primary ion species of $O_2^+$, a primary acceleration voltage of 3.0 kV and a detection region of 30 $\mu$m$\phi$. Fig. 14 shows the results of Dynamic SIMS. The observation results thereof revealed that the substrate is doped. In Fig. 14, the evaluation results before performing the laser irradiation are also shown for reference.

(Evaluation - SEM Analysis)

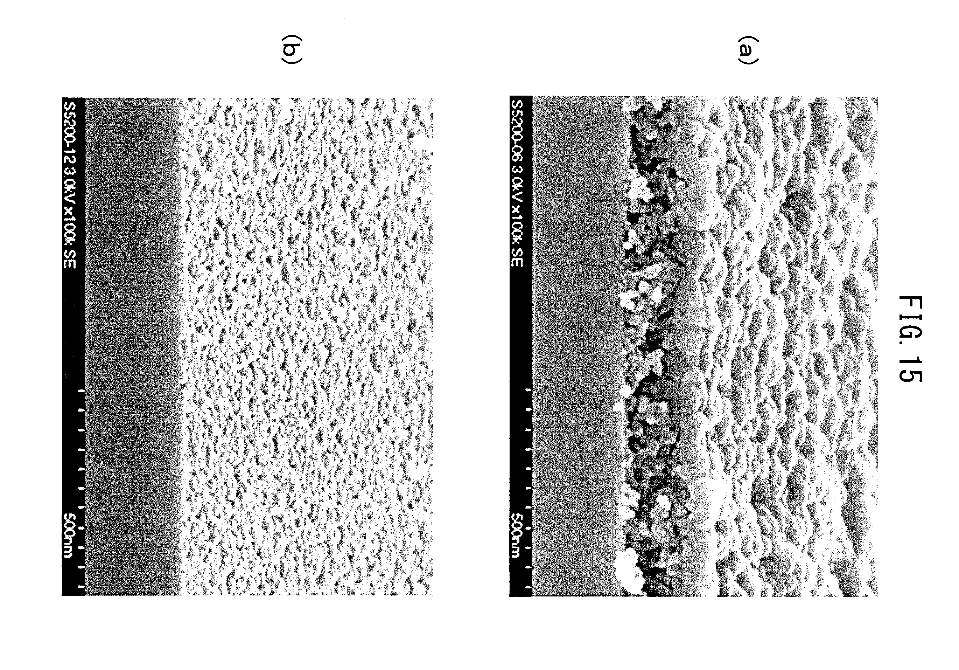

The cross-section of the produced substrate was observed at a sample tilt angle of 20° and a magnification of 100,000 by means of FE-SEM (field emission scanning electron microscopy) (Model S5200, manufactured by Hitachi High-Technologies Corp.), and the results thereof are shown in Fig. 15. Fig. 15(a) shows the observation results of the dopant injection layer before laser irradiation and Fig. 15(b) is the observation results of the dopant injection layer after laser irradiation.

It was confirmed from these observation results that the passivation layer (SiN layer) stacked on the dopant injection layer is ablated by laser irradiation and only a part of the silicon particle layer constituting the dopant injection layer is present on the base material surface.

<Example B2>

(Preparation of Silicon Particle)

Phosphorus-doped silicon particles were obtained in the same manner as in Example B1. The obtained phosphorus-doped silicon particles had an average primary particle diameter of about 7.4 nm.

(Preparation of Dispersion)

A silicon particle dispersion having a solid content concentration of 2 mass% was obtained in the same manner as in Example B1.

(Preparation of Substrate)

A silicon base material was cleaned in the same manner as in Example B1.

(Formation of Passivation Layer)

On the cleaned silicon base material, a silicon nitride (SiN) layer having a thickness of 50 nm was formed as a passivation layer (first passivation layer) in the same manner as in Example B1.

(Coating)

On the silicon base material having stacked thereon the passivation layer, the silicon particle dispersion was coated in a line width of 200 $\mu$m by an inkjet printer (Dimatix).

(Drying)

The substrate coated with the silicon particle dispersion was dried in the same manner as in Example B1 to form a silicon particle layer (thickness: 200 nm).

(Light Irradiation)

The laminate having the silicon particle layer on the passivation layer was irradiated with green laser in the same manner as in Example B1 to ablate the passivation layer and silicon particle layer.

(Evaluation - Dynamic SIMS Measurement)

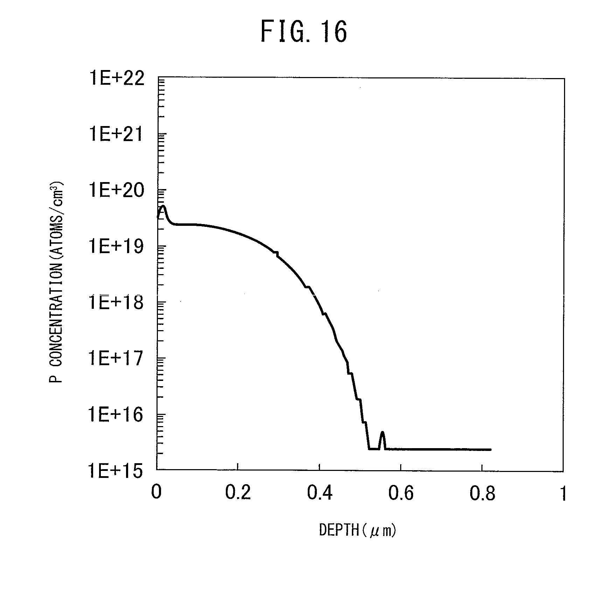

SIMS measurement was performed in the same manner as in Example B1. Fig. 16 shows the results. The observation results thereof revealed that the substrate is doped.

(Evaluation - SEM Analysis)

It was confirmed from SEM analysis that, similarly to Example B1, only a part of the silicon particle layer constituting the dopant injection layer is present on the base material surface.

<Example B3>

(Preparation of Boron (B)-Doped Silicon Particle)

The silicon particles were produced from a monosilane ($SiH_4$) gas as the raw material by a laser pyrolysis process using a carbon dioxide ($CO_2$) laser. At this time, a diborane ($B_2H_6$) gas was introduced together with the monosilane gas to obtain a boron-doped silicon particle.

The doping concentration of the obtained boron-doped silicon particles was $1 \times 10^{21}$ atoms/cm$^3$. Also, the obtained boron-doped silicon particles had an average primary particle diameter of about 19.7 nm. Incidentally, the average primary particle diameter of the silicon particles was calculated based on an aggregate of 500 or more particles by performing TEM observation and analyzing the image at a magnification of 100,000.

(Preparation of Dispersion)

A silicon particle dispersion having a solid content concentration of 2 mass% was obtained in the same manner as in Example B1.

(Preparation of Substrate)

A silicon base material was cleaned in the same manner as in Example B1.

(Formation of Passivation Layer)

On the cleaned silicon base material, a silicon nitride (SiN) layer having a thickness of 50 nm was formed as a passivation layer (first passivation layer) in the same manner as in Example B1.

(Coating)

On the silicon base material having stacked thereon the passivation layer, the silicon particle dispersion was coated in a line width of 200 $\mu$m by an inkjet printer (Dimatix).

(Drying)

The substrate coated with the silicon particle dispersion was dried in the same manner as in Example B1 to form a silicon particle layer (thickness: 200 nm).

(Light Irradiation)

The laminate having the silicon particle layer on the passivation layer was irradiated with green laser in the same manner as in Example B1 to ablate the passivation layer and silicon particle layer.

(Evaluation - Dynamic SIMS Measurement)

It was confirmed from SIMS analysis that, similarly to Example B1, the substrate is doped.

(Evaluation - SEM Analysis)

It was confirmed from SEM analysis that the passivation layer (SiN layer) stacked on the dopant injection layer is ablated by laser irradiation and only a part of the silicon particle layer constituting the dopant injection layer is present on the base material surface.

<Example B4>

(Preparation of Silicon Particle)

Boron-doped silicon particles were obtained in the same manner as in Example B3. The obtained boron-doped silicon particles had an average primary particle diameter of about 20.9 nm.

(Preparation of Dispersion)

A silicon particle dispersion having a solid content concentration of 2 mass% was obtained in the same manner as in Example B1.

(Preparation of Substrate)

A silicon base material was cleaned in the same manner as in Example B1.

(Formation of Passivation Layer)

On the cleaned silicon base material, a silicon nitride (SiN) layer having a thickness of 50 nm was formed as a passivation layer (first passivation layer) in the same manner as in Example B1.

(Coating)

On the silicon base material having stacked thereon the passivation layer, the silicon particle dispersion was coated in a line width of 200 $\mu$m by an inkjet printer (Dimatix).

(Drying)

The substrate coated with the silicon particle dispersion was dried in the same manner as in Example B1 to form a silicon particle layer (thickness: 200 nm).

(Light Irradiation)

The laminate having the silicon particle layer on the passivation layer was irradiated with green laser in the same manner as in Example B1 to ablate the passivation layer and silicon particle layer.

(Evaluation - Dynamic SIMS Measurement)

It was confirmed from SIMS analysis that, similarly to Example B2, the substrate is doped.

(Evaluation - SEM Analysis)

It was confirmed from SEM analysis that only a part of the silicon particle layer constituting the dopant injection layer is present on the base material surface.

<Example B5>

(Preparation of Silicon Particle)

Phosphorus-doped silicon particles were obtained in the same manner as in Example B1. The obtained phosphorus-doped silicon particles had an average primary particle diameter of about 7.2 nm.

(Preparation of Dispersion)

The silicon particles obtained above were ultrasonically dispersed in propylene glycol (PG) to obtain a silicon particle dispersion having a solid content concentration of 5 mass%.

(Preparation of Substrate)

A silicon base material was cleaned in the same manner as in Example B1.

(Coating)

The silicon particle dispersion was coated on the silicon substrate in a line width of 200 $\mu$m by screen printing.

(Drying)

The substrate coated with the silicon particle dispersion was dried on a hot plate at 200°C to remove propylene glycol as the dispersion medium in the silicon particle dispersion, and thereby form a silicon particle layer (thickness: 200 nm).

(Formation of Passivation Layer)

On the substrate having the silicon particle layer, a silicon nitride (SiN) layer having a thickness of 50 nm was formed as a passivation layer (first passivation layer) in the same manner as in Example B1.

(Light Irradiation)

The laminate having the passivation layer on the silicon particle layer was irradiated with green laser in the same manner as in Example B1 to ablate the silicon particle layer and passivation layer.

(Evaluation - Dynamic SIMS Measurement)

It was confirmed from SIMS analysis that, similarly to Example B1, the substrate is doped.

(Evaluation - SEM Analysis)

It was confirmed from SEM analysis that the passivation layer (SiN layer) stacked on the dopant injection layer is removed by laser irradiation and only a part of the silicon particle layer constituting the dopant injection layer is present on the base material surface.

«Third Aspect of the Present Invention»

Examples of the third aspect of the present invention are described below, but these Examples are a mere example for suitably explaining the third aspect of the present invention, and the third aspect of the present invention is not limited thereto by any means.

<<Example C1-1>>

(Preparation of Substrate)

A silicon substrate was ultrasonically cleaned for 5 minutes in each of acetone and isopropyl alcohol, then dipped in a 5% ammonium fluoride solution for 10 minutes and washed with pure eater.

(Dopant Composition)

A dopant compound-containing solution (P8545SF, produced by Filmtronics) and a silicon particle dispersion (solid content: 5 mass%) were mixed in a weight ratio of 1:1 to obtain a dopant composition.

(Formation of Dopant Injection Layer)

A few drops of the prepared dopant composition were dropped on the substrate and spin-coated at 500 rpm over 5 seconds and further at 4,000 rpm for 10 seconds to coat the dopant composition on the substrate, and thereby form a dopant injection layer.

(Light Irradiation)

The substrate having the dopant injection layer was irradiated with green laser (wavelength: 532 nm) by using a laser light irradiation apparatus (trade name: Osprey 532-8-0-2, manufactured by Quantronix) to dope the dopant into the substrate. The laser irradiation conditions were an irradiation energy of 700 mJ/(cm$^2$·shot) and a number of shots of 20, and laser irradiation was performed in a nitrogen (N$_2$) atmosphere.

<<Example C1-2>>

Formation of a dopant injection layer and laser irradiation for the dopant injection layer were performed as in Example C1-1 except that as the dopant composition, a dopant compound-containing solution (P8545SF, produced by Filmtronics) and a silicon particle dispersion (solid content: 5 mass%) were mixed in a weight ratio of 3:1.

<<Example C1-3>>

Formation of a dopant injection layer and laser irradiation for the dopant injection layer were performed as in Example C1-1 except that as the dopant composition, a dopant compound-containing solution (P8545SF, produced by Filmtronics) and a silicon particle dispersion (solid content: 5 mass%) were mixed in a weight ratio of 1:3.

<<Comparative Example C1>>

Laser irradiation for the dopant injection layer was performed as in Example C1-1 except that as the dopant composition, a dopant compound-containing solution (P8545SF, produced by Filmtronics) was used alone.

«Example C2»

(Dopant Composition)

A dopant compound-containing solution (P8545SF, produced by Filmtronics) and a silicon particle dispersion (solid content: 5 mass%) were not mixed but used individually.

(Formation of Dopant Injection Layer)

A few drops of the dopant compound-containing solution (P8545SF, produced by Filmtronics) were dropped on the substrate and spin-coated at 500 rpm over 5 seconds and further at 4,000 rpm for 10 seconds to coat the dopant composition on the substrate, and thereby form a dopant compound-containing layer.
Thereafter, the silicon particle dispersion (solid content: 5 mass%) was further coated on the dopant compound-containing layer in the same manner to form a light-absorbing particle-containing layer, and thereby obtain a laminate having the following configuration:

```
          (substrate)/light-absorbing particle-containing
      layer/dopant compound-containing layer.
```

«Example C3»

(Formation of Dopant Injection Layer)

A dopant compound-containing layer was formed on a light-absorbing particle-containing layer by reversing the stacking order of Example C2 to obtain a laminate having the following configuration:

```
          (substrate)/dopant compound-containing layer/light-
      absorbing particle-containing layer.
```

<<Evaluation 1 - Damage to Substrate>>

The substrates of Examples C1-1 to C1-3 and Comparative Example C1 after laser irradiation were confirmed for the surface state. In Examples C1-1 to C1-3, damage such as crack was not observed in the substrate after laser irradiation, whereas in Comparative Example C1, a crack was observed in the substrate after laser irradiation.

«Evaluation 2 - Transmittance»

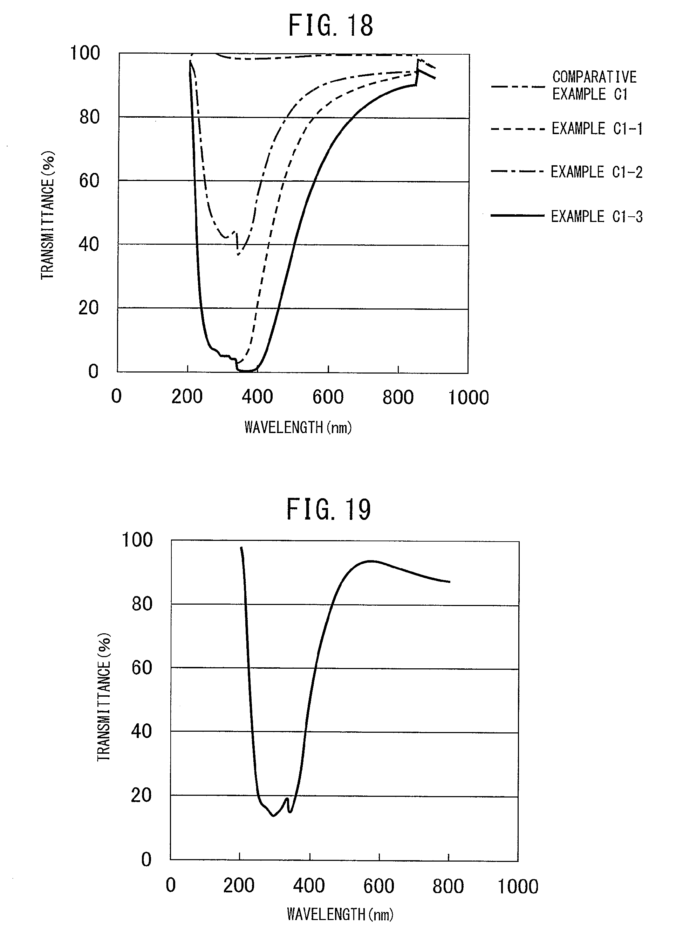

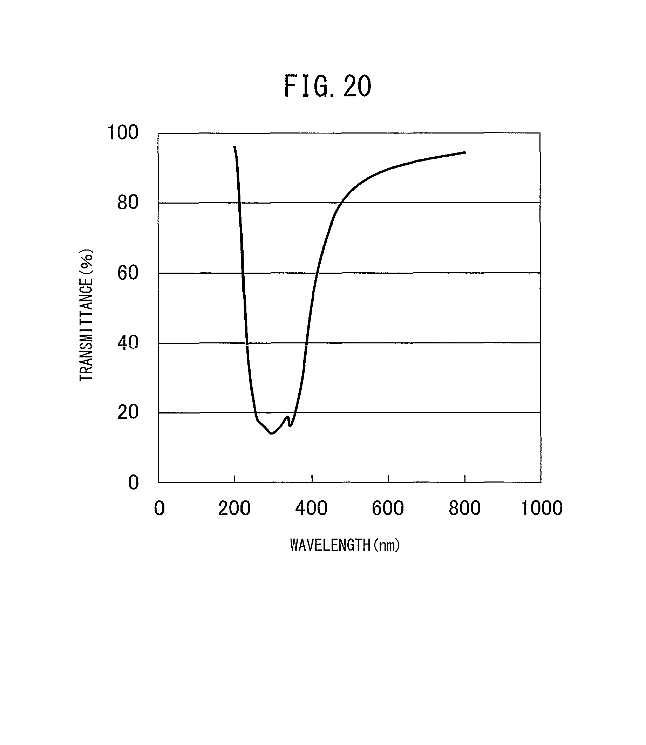

For reference, dopant injection layers were formed as in Examples and Comparative Example above except for using a glass base material as the substrate and measured for the transmittance by means of a spectrophotometer (Spectrophotometer, U-4000, manufactured by Hitachi, Ltd.). Fig. 18 shows the results for Examples C1-1 to C1-3 and Comparative Example C1, Fig. 19 shows the results for Example C2, and Fig. 20 shows the results for Example C3.
As understood from Fig. 18, the dopant injection layers of Examples C1-1 to C1-3 containing silicon particles have a peak absorption wavelength in the range of 200 to 300 nm and in turn, have a significant absorptivity for light at a wavelength of 532 nm used for light irradiation. On the other hand, it is understood that the dopant injection layer of Comparative Example C1 containing no silicon particles substantially fails in absorbing the light at a wavelength of 532 nm used for light irradiation.
Also, as understood from Figs. 19 and 20, even when a light-absorbing particle-containing layer and a dopant compound-containing layer are stacked, the laminate has a peak absorption wavelength in the range of 200 to 300 nm and in turn, has a significant absorptivity for light at a wavelength of 532 nm used for light irradiation.

«Evaluation 3 - SIMS»

Dynamic SIMS (dynamic secondary ion mass spectrometry) of the substrates of Example C1-1 and Comparative Example C1 was performed using CAMECA IMS-7f. The measurement conditions were a primary ion species of $O_2{}^+$, a primary acceleration voltage of 3.0 kV and a detection region of 30 $\mu$m$\phi$.
The surface dopant concentration of Example C1-1 was $5 \times 10^{19}$ atoms/cm$^3$, and the surface dopant concentration of Comparative Example C1-1 was $2 \times 10^{19}$ atoms/cm$^3$. From these results, it is understood that the dopant injection layer of Example C1-1 containing silicon particles absorbed light at a wavelength of 532 nm used for light irradiation and efficient dopant diffusion was thereby caused.

«Evaluation 4 - Measurement of Resistivity»

The substrates of Examples C1-1 to C1-3 and Comparative Example C1 were measured for the surface resistivity by means of a resistivity meter (MCP-T360 manufactured by Mitsubishi Chemical Corporation).
The surface resistivities of the substrates of Examples C1-1 to C1-3 and Comparative Example C1 were as follows:

Example C1-1: 36 $\Omega$/square
Example C1-2: 35 $\Omega$/square
Example C1-3: 22 $\Omega$/square
Comparative Example C1: 78 $\Omega$/square

From these results, it is understood that in the substrates of Examples C1-1 to C1-3, efficient dopant diffusion occurred and a low surface resistivity was thereby obtained.

[Description of Numerical References]

A1: Silicone particle dispersion layer
A2: Green silicone particle layer
A3: Light-transmitting layer
A5: Sintered silicon particle layer
A7: Opening part
A10: Substrate
A15: Irradiated light
A30: Amorphous silicon layer

A40: Silicon particle layer
S: Source electrode
G: Gate electrode
D: Drain electrode
B2: Dopant injection layer
B5: Laser light
B12, B22, B32, B42, B44, B52, B54: Electrode
B15, B25, B35, B45, B55, B65: Semiconductor layer or substrate
B15a, B25a, B35a, B45a, B45b, B55a, B65a: Doped layer in first or second region
B18, B28, B38a, B38b, B46, B48, B56, B58, B68: Passivation layer
B40: Back-contact solar cell
B50: PERL solar cell
B45c, B55c: Doped layer
B68a: Hole Passivation layer
B72: Diffusion mask layer
B72a: Hole of diffusion mask layer
B74: Vitreous dopant injection layer
B100: Light incident on solar cell
C10: Irradiated light
C22: Dopant injection layer of third aspect of the present invention
C23: Conventional dopant injection layer
C24: Dopant compound-containing layer of third aspect of the present invention
C26: Light-absorbing particle-containing layer of third aspect of the present invention
C30: Semiconductor substrate

**Claims**

1. A method for producing a semiconductor laminate having a substrate and a sintered silicon particle layer on the substrate, comprising:

   (a) coating a silicon particle dispersion containing a dispersion medium and silicon particles dispersed in said dispersion medium, on a substrate to form a silicon particle dispersion layer,
   (b) drying said silicon particle dispersion layer to form a green silicon particle layer,
   (c) stacking a light-transmitting layer on said green silicon particle layer, and
   (d) irradiating said green silicon particle layer with light through said light-transmitting layer to sinter said silicon particles constituting said green silicon particle layer, and thereby form a sintered silicon particle layer.

2. The method according to claim 1, wherein said light-transmitting layer is retained after the light irradiation of the step (d).

3. The method according to claim 1, wherein said light-transmitting layer is removed by the light irradiation of the step (d).

4. The method according to any one of claims 1 to 3, wherein said light-transmitting layer contains any one of an organic compound, an inorganic compound and an organic-inorganic hybrid compound.

5. The method according to any one of claims 1 to 4, wherein said light-transmitting layer contains a silicon compound.

6. The method according to any one of claims 1 to 5, wherein said light-transmitting layer contains silicon oxide or a compound having a siloxane bond.

7. The method according to any one of claims 1 to 6, wherein said light-transmitting layer is formed of spin-on-glass.

8. The method according to any one of claims 1 to 7, wherein said light-transmitting layer is formed by a liquid phase process.

9. The method according to any one of claims 1 to 8, wherein said light-transmitting layer has a volume resistivity of $10^{12}$ $\Omega \cdot$cm or more.

10. The method according to any one of claims 1 to 9, wherein said light-transmitting layer has a film thickness of 50 to 1,000 nm.

11. The method according to any one of claims 1 to 10, wherein said sintered silicon particle layer has a film thickness of 50 to 500 nm.

12. The method according to any one of claims 1 to 11, wherein said light irradiation is performed using a laser.

13. The method according to claim 12, wherein the wavelength of said laser is 600 nm or less.

14. The method according to any one of claims 1 to 13, wherein said light irradiation is performed in a non-oxidizing atmosphere.

15. The method according to any one of claims 1 to 13, wherein said light irradiation is performed in an atmospheric atmosphere.

16. A semiconductor laminate having a substrate and a sintered silicon particle layer on the substrate, which is produced by the method of any one of claims 1 to 15.

17. A semiconductor device comprising the semiconductor laminate according to claim 16.

18. A method for manufacturing a top-gate top-contact thin-film transistor, comprising producing a semiconductor laminate having a substrate and a sintered silicon particle layer on the substrate by the method of claim 2, removing a part of said light-transmitting layer from said semiconductor laminate to form an opening part reaching said sintered silicon particle layer, providing said opening parts with a source electrode and a drain electrode, and forming a gate electrode on said light-transmitting layer.

19. A top-gate top-contact thin-film transistor manufactured by the method of claim 18.

20. A green silicon laminate, comprising:

   (a) a substrate,
   (b) a green silicon particle layer stacked on said substrate and formed of silicon particles, and
   (c) a light-transmitting layer stacked on said green silicon particle layer.

21. A semiconductor laminate, comprising:

   (a) a substrate,
   (b) a sintered silicon particle layer stacked on said substrate and formed of silicon particles, and
   (c) a light-transmitting layer stacked on said sintered silicon particle layer.

22. A semiconductor laminate, comprising:

   (a) a glass substrate, and
   (b) a sintered silicon particle layer stacked directly on said glass substrate and formed of silicon particles, the sintered silicon particle layer having an arithmetic mean roughness of 100 nm or less.

23. A method for manufacturing a semiconductor device, comprising forming a first doped layer in a first region of a semiconductor layer or substrate by the following steps:

   providing a laminate having the following (i) and (ii): (i) first and/or second passivation layers disposed on said semiconductor layer or substrate, and (ii) a first dopant injection layer disposed in the region corresponding to said first region above the first passivation layer but below the second passivation layer, in which the dopant injection layer is composed of first particles, and said first particles are substantially formed of the same element as said semiconductor layer or substrate and is doped with a p-type or n-type dopant, and
   irradiating the region corresponding to said first dopant injection layer of said laminate with light, thereby doping said first region with said p-type or n-type dopant to form said first doped layer and at least partially removing the region corresponding to said dopant injection layer out of said first dopant injection layer and said passivation layer.

24. The method according to claim 23, comprising the following steps:

depositing said first passivation layer on said semiconductor layer or substrate,
applying a first dispersion containing first particles to, out of said first passivation layer, the region corresponding to said first region, said first particles being substantially formed of the same element as said semiconductor layer or substrate and being doped with a p-type or n-type dopant,
drying said first dispersion applied, thereby forming said first dopant injection layer, and
irradiating said first dopant injection layer with light, thereby doping said first region with said p-type or n-type dopant to form said first doped layer and at least partially removing the region corresponding to said first dopant injection layer out of said first dopant injection layer and said first passivation layer.

25. The method according to claim 23, comprising the following steps:

applying a first dispersion containing first particles to said first region, said first particles being substantially formed of the same element as said semiconductor layer or substrate and being doped with a p-type or n-type dopant,
drying said first dispersion applied, thereby forming said first dopant injection layer,
depositing said second passivation layer on said semiconductor layer or substrate and said first dopant injection layer, and
irradiating, out of said second passivation layer, the region corresponding to said first dopant injection layer with light, thereby doping said first region with said p-type or n-type dopant to form said first doped layer and at least partially removing the region corresponding to said first dopant injection layer out of said first dopant injection layer and said second passivation layer.

26. The method according to claim 23, comprising the following steps:

depositing said first passivation layer on said semiconductor layer or substrate,
applying a first dispersion containing first particles to, out of said first passivation layer, the region corresponding to said first region, said first particles being substantially formed of the same element as said semiconductor layer or substrate and being doped with a p-type or n-type dopant,
drying said first dispersion applied, thereby forming said first dopant injection layer,
depositing a second passivation layer on said first passivation layer and said first dopant injection layer, and
irradiating, out of said second passivation layer, the region corresponding to said first dopant injection layer with light, thereby doping said first region with said p-type or n-type dopant to form said first doped layer and at least partially removing the region corresponding to said first dopant injection layer out of said first dopant injection layer and said first and second passivation layers.

27. The method according to any one of claims 23 to 26, further comprising forming an electrode through said passivation layer to come into contact with said first doped layer.

28. The method according to any one of claims 23 to 27, wherein the concentration of said dopant is $1\times10^{17}$ atoms/cm$^3$ or more at a depth of 0.1 $\mu$m from the surface of said first region.

29. The method according to any one of claims 23 to 28, wherein said passivation layer has a film thickness of 1 to 200 nm.

30. The method according to any one of claims 23 to 29, wherein said passivation layer is formed of a material selected from the group consisting of SiN, $SiO_2$, $Al_2O_3$ and a combination thereof.

31. The method according to any one of claims 23 to 30, wherein said semiconductor layer or substrate is a semiconductor layer or substrate of silicon, germanium or a combination thereof.

32. The method according to any one of claims 23 to 31, wherein said dispersion is applied by a printing method.

33. The method according to any one of claims 23 to 32, wherein the average primary particle diameter of said particles is 100 nm or less.

**34.** The method according to any one of claims 23 to 33, further comprising forming a second doped layer in a second region of the semiconductor layer or substrate by the following steps:

applying a second dispersion containing second particles to a second region of said semiconductor layer or substrate, simultaneously with application of said first dispersion, between application and drying of said first dispersion, between drying of said first dispersion and removal of said first dopant injection layer, or after removal of said first dopant injection layer, said second particles being substantially formed of the same element as said semiconductor layer or substrate and being doped with a dopant of a type different from the dopant of said first particle,

drying said second dispersion applied, simultaneously with drying of said first dispersion or separately from drying of said first dispersion, thereby forming a second dopant injection layer, and

irradiating said second dopant injection layer with light, simultaneously with light irradiation of said first dopant injection layer or separately from light irradiation of said first dopant injection layer, thereby doping said second region with said p-type or n-type dopant to form said second doped layer and at least partially removing the region corresponding to said second dopant injection layer out of said second dopant injection layer and said first and/or second passivation layers.

**35.** The method according to claim 34, further comprising forming an electrode through said passivation layer to come into contact with said second doped layer.

**36.** The method according to claim 34 or 35, wherein said semiconductor device is a solar cell.

**37.** A semiconductor device,
wherein a passivation layer is stacked on a semiconductor substrate or layer;
wherein, in a first region of said semiconductor substrate or layer, said passivation layer is at least partially removed, first particles are sintered to said semiconductor substrate or layer, and a first electrode reaching said first region through said passivation layer is formed via said first particle;
wherein said first particles are substantially formed of the same element as said semiconductor layer or substrate and is doped with a p-type or n-type dopant; and
wherein the concentration of said dopant is $1\times10^{17}$ atoms/cm$^3$ or more at a depth of 0.1 $\mu$m from the surface of said first region.

**38.** The semiconductor device according to claim 37,
wherein, in a second region of said semiconductor substrate or layer, said passivation layer is at least partially removed, second particles are sintered to said semiconductor substrate or layer, and a second electrode reaching said second region through said passivation layer is formed via said second particle;
wherein said second particles are substantially formed of the same element as said semiconductor layer or substrate and is doped with a dopant of a type different from the dopant of said first particle; and
wherein the concentration of said dopant is $1\times10^{17}$ atoms/cm$^3$ or more at a depth of 0.1 $\mu$m from the surface of said second region.

**39.** The semiconductor device according to claim 37 or 38, which is a solar cell.

**40.** A dopant composition, comprising:

a solvent,
a dopant compound having a dopant element, and
light-absorbing particles composed of a material having at least one peak absorption wavelength in the range of 100 to 1,000 nm.

**41.** The composition according to claim 40, wherein said light-absorbing particles are composed of silicon, germanium or a combination thereof.

**42.** The composition according to claim 40 or 41, wherein said light-absorbing particles have an average primary particle diameter of 100 nm or less.

**43.** The composition according to any one of claims 40 to 42, wherein the peak at said peak absorption wavelength is a maximum peak in the range of 200 to 2,500 nm.

**44.** The composition according to any one of claims 40 to 43, wherein said light-absorbing particles contain substantially no dopant.

**45.** The composition according to any one of claims 40 to 44, wherein said light-absorbing particles are doped with a dopant.

**46.** A dopant injection layer, comprising:

a dopant compound having a dopant element, and
light-absorbing particles composed of a material having at least one peak absorption wavelength in the range of 100 to 1,000 nm.

**47.** A dopant injection layer, comprising the following layers stacked one on another:

a dopant compound-containing layer containing a dopant compound having a dopant element, and
a light-absorbing particle-containing layer containing light-absorbing particles composed of a material having a peak absorption wavelength in the range of 100 to 1,000 nm.

**48.** The dopant injection layer according to claim 47, wherein said dopant compound-containing layer is stacked on said light-absorbing particle-containing layer.

**49.** The dopant injection layer according to claim 47, wherein said light-absorbing particle-containing layer is stacked on said dopant compound-containing layer.

**50.** The dopant injection layer according to any one of claims 47 to 49, wherein said dopant compound-containing layer further contains light-absorbing particles composed of a material having a peak absorption wavelength in the range of 100 to 1,000 nm.

**51.** The dopant injection layer according to any one of claims 47 to 50, wherein said light-absorbing particle-containing layer further contains a dopant compound having a dopant element.

**52.** The dopant injection layer according to any one of claims 46 to 51, which is stacked on a semiconductor substrate.

**53.** The dopant injection layer according to claim 52, wherein said light-absorbing particles are composed of the same element as said semiconductor substrate.

**54.** A method for forming a doped layer, comprising irradiating said dopant injection layer according to claim 52 or 53 with light to diffuse said dopant element into said semiconductor substrate.

**55.** The method according to claim 54, wherein said light-absorbing particles have, at the main wavelength of said irradiated light, a light absorptivity of 0.1 times or more the light absorptivity at said peak absorption wavelength.

**56.** The method according to claim 54 or 55, wherein said irradiated light is laser light.

**57.** A method for manufacturing a semiconductor device, comprising forming a doped layer by the method of any one of claims 54 to 56.

**58.** The method according to claim 57, wherein said semiconductor device is a solar cell.

**59.** A semiconductor device manufactured by the method of claim 57 or 58.

# FIG. 1

(a) A1 / A10

(b) A2

(c) A2 / A3

(d) A15 / A3

(d1) A5 / A3

(d2) A5

# FIG. 2

(d1)

(d1-1)

(d1-2)

# FIG. 3

(a)

A15

A30

(b)

A30b

A30a

# FIG. 4

(a)

A15

A40

(b)

A40a

A40b

# FIG. 5

(a)

A56

A54

A52

SS200-09 3.0kV x10.0k SE                    500nm

(b)

SS200-10 3.0kV x10.0k SE                    500nm

(c)

A54

A52

SS200-14 3.0kV x10.0k SE                    500nm

(d)

SS200-20 3.0kV x10.0k SE                    500nm

FIG. 6

(a)

(b)

(c)

(d)

FIG. 7

# FIG. 8

(a)

n      B15

(b)

B18
B15

n

(c)

B2      B2

n+      n+      B18
B15

n

(d)

B5      B5
B15a      B15a   B18
n+     n+    B15

n

(e)

B12      B12
B18
n+     n+    B15

n

# FIG. 9

(a)

n

B25

(b)

B2    B2

n⁺    n⁺

n

B25

(c)

B28
B25

n⁺    n⁺

n

(d)

B5      B5
B25a    B25a    B28

n⁺    n⁺    B25

n

(e)

B22    B22

B28
B25

n⁺    n⁺

n

# FIG. 10

# FIG. 11

B100

B40

B46
B45c

$n^+$

B45

n(p)

$n^+$          $p^+$

B45a          B45b          B48

B42          B44

# FIG. 12

B100

B50

B52          B52

B56
B55c

$n^+$

B55

p

$p^+$          $p^+$          B58

B55a          B55a          B54

# FIG. 13

(a)

(b)

(c)

(d)

(e)

(f)

(g)

(h)

## FIG. 14

# FIG. 15

(a)

S5200-06 3.0kV x100k SE    500nm

(b)

S5200-12 3.0kV x100k SE    500nm

# FIG. 16

# FIG. 17

(a)

C10

C22
C30

C10a

(b)

C10

C23
C30

CONVENTIONAL TECHNIQUE

(c)

C10

C24
C26
C30

C10a

(d)

C10

C26
C24
C30

C10a

# FIG. 18

COMPARATIVE
EXAMPLE C1

EXAMPLE C1-1

EXAMPLE C1-2

EXAMPLE C1-3

# FIG. 19

FIG. 20

## INTERNATIONAL SEARCH REPORT

International application No.

PCT/JP2013/059629

### A. CLASSIFICATION OF SUBJECT MATTER

*H01L21/20*(2006.01)i, *H01L21/208*(2006.01)i, *H01L21/225*(2006.01)i, *H01L21/336*(2006.01)i, *H01L29/786*(2006.01)i, *H01L31/04*(2006.01)i

According to International Patent Classification (IPC) or to both national classification and IPC

### B. FIELDS SEARCHED

Minimum documentation searched (classification system followed by classification symbols)

H01L21/20, H01L21/208, H01L21/225, H01L21/336, H01L29/786, H01L31/04

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2013 |
| Kokai Jitsuyo Shinan Koho | 1971-2013 | Toroku Jitsuyo Shinan Koho | 1994-2013 |

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X<br><br>Y | JP 2004-87546 A (JSR Corp.),<br>18 March 2004 (18.03.2004),<br>entire text (particularly, paragraphs [0018],<br>[0029]); all drawings<br>& US 2005/0145163 A1    & EP 1551057 A1<br>& WO 2004/019393 A1    & DE 60328302 D<br>& KR 10-2005-0026692 A  & CN 1579012 A<br>& AU 2003262236 A | 1,4,5,9-17,<br>20<br>2-3,6-8,18,<br>19,21,22 |
| X<br><br>Y | JP 2004-204094 A (JSR Corp.),<br>22 July 2004 (22.07.2004),<br>entire text (particularly, paragraphs [0037],<br>[0057]); all drawings<br>& US 2005/0145163 A1    & EP 1551057 A1<br>& WO 2004/019393 A1    & DE 60328302 D<br>& KR 10-2005-0026692 A  & CN 1579012 A<br>& AU 2003262236 A | 1,4,5,9-17,<br>20<br>2-3,6-8,18,<br>19,21,22 |

[X] Further documents are listed in the continuation of Box C.  ☐ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| 05 July, 2013 (05.07.13) | 16 July, 2013 (16.07.13) |

| Name and mailing address of the ISA/<br>Japanese Patent Office | Authorized officer |
|---|---|
| Facsimile No. | Telephone No. |

Form PCT/ISA/210 (second sheet) (July 2009)

**INTERNATIONAL SEARCH REPORT**

International application No.

PCT/JP2013/059629

C (Continuation). DOCUMENTS CONSIDERED TO BE RELEVANT

| Category* | Citation of document, with indication, where appropriate, of the relevant passages | Relevant to claim No. |
|---|---|---|
| Y | JP 2009-111053 A (Semiconductor Energy Laboratory Co., Ltd.), 21 May 2009 (21.05.2009), paragraphs [0034] to [0037]; fig. 3 (Family: none) | 2,3,6-8,18, 19,21,22 |
| Y | WO 2010/113376 A1 (Panasonic Corp.), 07 October 2010 (07.10.2010), entire text; fig. 5, 7, 12 & JP 2011-101027 A & US 2012/0001173 A1 & CN 102318073 A | 2,6,21 |
| Y | JP 2004-296731 A (Advanced LCD Technologies Development Center Co., Ltd.), 21 October 2004 (21.10.2004), entire text; fig. 1 to 8 (Family: none) | 3,6,22 |
| Y | JP 2010-258352 A (Oki Data Corp.), 11 November 2010 (11.11.2010), paragraph [0029] (Family: none) | 7 |
| Y | JP 2009-31045 A (Seiko Epson Corp.), 12 February 2009 (12.02.2009), paragraph [0013] (Family: none) | 8 |
| A | JP 2011-258824 A (Fuji Xerox Co., Ltd.), 22 December 2011 (22.12.2011), paragraph [0069] (Family: none) | 9 |
| X A | JP 2012-178546 A (Teijin Ltd.), 13 September 2012 (13.09.2012), entire text; all drawings & WO 2012/077797 A1 & TW 201251085 A | 37-39 23-36 |
| X A | WO 2012/077797 A1 (Teijin Ltd.), 14 June 2012 (14.06.2012), entire text; all drawings & EP 2594114 A1 & CN 103004289 A | 37-39 23-36 |
| A | JP 2005-228792 A (Seiko Epson Corp.), 25 August 2005 (25.08.2005), entire text; all drawings (Family: none) | 23-39 |
| X A | JP 2010-3834 A (Tokyo University of Agriculture and Technology), 07 January 2010 (07.01.2010), entire text; all drawings (Family: none) | 47,49,52-59 40-46,48,50, 51 |

Form PCT/ISA/210 (continuation of second sheet) (July 2009)

**INTERNATIONAL SEARCH REPORT**

| International application No. |
| --- |
| PCT/JP2013/059629 |

C (Continuation). DOCUMENTS CONSIDERED TO BE RELEVANT

| Category* | Citation of document, with indication, where appropriate, of the relevant passages | Relevant to claim No. |
| --- | --- | --- |
| A | JP 2001-253706 A (JSR Corp.),<br>18 September 2001 (18.09.2001),<br>entire text; all drawings<br>& US 2001/0021760 A1 & EP 1134224 A2<br>& DE 60128611 D & KR 10-2001-0091967 A<br>& TW 281921 B | 1-22 |
| A | JP 2005-79468 A (JSR Corp.),<br>24 March 2005 (24.03.2005),<br>entire text; all drawings<br>(Family: none) | 1-22 |

Form PCT/ISA/210 (continuation of second sheet) (July 2009)

**INTERNATIONAL SEARCH REPORT**

| International application No. |
| --- |
| PCT/JP2013/059629 |

**Box No. II        Observations where certain claims were found unsearchable (Continuation of item 2 of first sheet)**

This international search report has not been established in respect of certain claims under Article 17(2)(a) for the following reasons:

1. ☐ Claims Nos.:
   because they relate to subject matter not required to be searched by this Authority, namely:

2. ☐ Claims Nos.:
   because they relate to parts of the international application that do not comply with the prescribed requirements to such an extent that no meaningful international search can be carried out, specifically:

3. ☐ Claims Nos.:
   because they are dependent claims and are not drafted in accordance with the second and third sentences of Rule 6.4(a).

**Box No. III        Observations where unity of invention is lacking (Continuation of item 3 of first sheet)**

This International Searching Authority found multiple inventions in this international application, as follows:
     See extra sheet.

1. ☒ As all required additional search fees were timely paid by the applicant, this international search report covers all searchable claims.

2. ☐ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☐ No required additional search fees were timely paid by the applicant.   Consequently, this international search report is restricted to the invention first mentioned in the claims; it is covered by claims Nos.:

**Remark on Protest**          ☒ The additional search fees were accompanied by the applicant's protest and, where applicable, the payment of a protest fee.

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet (2)) (July 2009)

**INTERNATIONAL SEARCH REPORT**

| International application No. |
| --- |
| PCT/JP2013/059629 |

Continuation of Box No.III of continuation of first sheet(2)

The invention of claim 1 is relevant to an invention disclosed in the document 1 or the document 2, and therefore, the invention of claim 1 is lack in novelty.

Consequently, the invention of claim 1 does not have a special technical feature.

As a result of judgment on the basis of special technical features at the time of the order for payment of additional fees, the present application are classified into five inventions each of which has a special technical feature as indicated below.

Meanwhile, the invention of claim 1 having no special technical feature is classified into invention 1.

(Invention 1) claims 1-22

The invention of claim 2, which refers to claim 1, has a special technical feature.

Consequently, the inventions of claims 4-15 and 18, which respectively refer to claim 2 and have a category same as that of claim 1, are classified into invention 1.

Further, the inventions of claims 3-15 referring to claim 1 and the inventions of claims 16, 17 and 19-22 are classified into invention 1, since it is efficient to carry out a search with respect to claims 16, 17 and 19-22 and claim 1 in a lump.

(Invention 2) claims 23-36

The invention of claim 23 has a special technical feature at the time of the order for payment of additional fees with respect to Invention 2.

(Invention 3) claims 37-39

The invention of claim 37 has a special technical feature at the time of the order for payment of additional fees with respect to Invention 3.

(Invention 4) claims 40-46 and 52-59

A configuration of "a light absorbing particle comprising a material having at least one peak absorption wavelength in a range of 100 to 1000 nm" has a special technical feature of the invention 4 at the time when the additional fees are invited.

(Invention 5) claims 47-59 (excluding the parts which are classified into Invention 4)

The invention of claim 47 has a special technical feature at the time of the order for payment of additional fees with respect to Invention 5.

Form PCT/ISA/210 (extra sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP H2163935 A
- JP 2006261681 A
- US 7704866 B
- JP 2010519731 A
- JP 2010514585 A
- JP 2006080450 A
- JP 2005150609 A
- US 7923368 B
- JP 2012019162 A
- JP 2010003834 A

### Non-patent literature cited in the description

- *International Journal of Photoenergy,* vol. 2012, 413863